# EUROPEAN PATENT APPLICATION

(11) **EP 4 726 722 A1**
(43) Date of publication of application: **15.04.2026**
(21) Application number: 25191074.1
(22) Date of filing: 22.07.2025
(51) Int. Cl.: G11C 8/12

(54) **NONVOLATILE MEMORY DEVICE AND STORAGE DEVICE**

(30) Priority: 14.10.2024 KR 20240139124
(71) Applicant: Samsung Electronics Co., Ltd., Suwon-si, Gyeonggi-do 16677 (KR)
(72) Inventor: KIM, Sangyun, 16677 Suwon-si (KR); KANG, Hyunsuk, 16677 Suwon-si (KR); KANG, Kyoungtae, 16677 Suwon-si (KR); KANG, Dongku, 16677 Suwon-si (KR); BYUN, Jindo, 16677 Suwon-si (KR); CHOI, Youngdon, 16677 Suwon-si (KR)
(74) Representative: Marks & Clerk LLP

(57) **Abstract**

A storage device includes nonvolatile memory chips including a first nonvolatile memory chip and a second nonvolatile memory chip and a storage controller. The first nonvolatile memory chip includes a first chip enable interface circuit and a first chip interface pin connected to the first chip enable interface circuit performs a first DMA operation, internally generates a self termination signal indicating that the first DMA operation is completed and transfers the self termination signal to the second nonvolatile memory chip through the first chip interface pin. The second nonvolatile memory chip includes a second chip interface pin and a second chip enable interface circuit connected to the second chip interface pin, is self-enabled based on the self termination signal and performs a second DMA operation without a selection chip enable command from the storage controller.

## Description

### BACKGROUND

Semiconductor memory devices for storing data may be classified into volatile memory devices and nonvolatile memory devices. Volatile memory devices, such as dynamic random access memory (DRAM) devices, are typically configured to store data by charging or discharging capacitors in memory cells, and lose the stored data when power is off.

Nonvolatile memory devices, such as flash memory devices, are widely used for storing a great amount of data. Recently, in the nonvolatile memory devices, data input/output (I/O) speed increases for processing the great amount of data and I/O efficiency is reduced because of direct memory access (DMA) overhead.

### SUMMARY

Some example implementations may provide a storage device that is self-terminated and/or self-enabled without external command.

Some example implementations may provide a nonvolatile memory device that is self-terminated and/or self-enabled without external command.

According to some example implementations, a storage device includes a plurality of nonvolatile memory chips including a first nonvolatile memory chip and a second nonvolatile memory chip and a storage controller to control the plurality of nonvolatile memory chips. The first nonvolatile memory chip includes a first memory cell array, a first chip enable interface circuit, a first chip interface pin connected to the first chip enable interface circuit and a first control circuit to control an operation of the first nonvolatile memory chip. The first nonvolatile memory chip, based on a first data output command from a storage controller, is configured to perform a first direct memory access (DMA) operation to transmit a first read data from the first memory cell array to the storage controller. The first chip enable interface circuit is configured to internally generate a first self termination signal indicating that the first DMA operation is completed based on a first start address associated with the first read data, and provide the first self termination signal to the second nonvolatile memory chip through the first chip interface pin. The second nonvolatile memory chip includes a second chip interface pin configured to receive the first self termination signal and a second chip enable interface circuit connected to the second chip interface pin. The second nonvolatile memory chip is self-enabled based on the first self termination signal from the first nonvolatile memory chip.

According to some example implementations, a nonvolatile memory device includes a memory cell array including a plurality of memory planes that include a first memory plane and a second memory plane, a plurality of page buffer circuits corresponding to a plurality of memory planes, a data input/output (I/O) circuit connected to the plurality of page buffer circuits through corresponding data lines, a chip enable interface circuit, a chip interface pin connected to the chip enable interface circuit and a control circuit to control an operation of the nonvolatile memory device. Each of the plurality of page buffer circuits is connected to respective one of the plurality of memory planes through corresponding bit-lines. The control circuit, based on a first data output command from a storage controller, is configured to perform a first direct memory access (DMA) operation to output a first read data from the first memory plane to a storage controller through the data I/O circuit, is configured to receive a second data output command from the storage controller based on the first DMA operation is being performed. The chip enable interface circuit is configured to generate a self termination signal indicating that the first DMA operation is completed based on a first start address associated with the first read data and generate a self enable signal based on the self termination signal. The control circuit, in response to the second data output command and the self enable signal, is configured to perform a second DMA operation to output a second read data from the second memory plane to the storage controller through the data I/O circuit.

According to some example implementations, a storage device includes a plurality of nonvolatile memory chips including a first nonvolatile memory chip and a second nonvolatile memory chip and a storage controller configured to control the plurality of nonvolatile memory chips. The first nonvolatile memory chip includes a first memory cell array, a first chip enable interface circuit, a first chip interface pin connected to the first chip enable interface circuit and a first control circuit configured to control an operation of the first nonvolatile memory chip. The first nonvolatile memory chip, based on a first data output command from the storage controller, is configured to perform a first direct memory access (DMA) operation to transmit a first read data from the first memory cell array to the storage controller. The first chip enable interface circuit is configured to generate a first self termination signal indicating that the first DMA operation is completed based on a first start address associated with the first read data, and is configured to provide the first self termination signal to the second nonvolatile memory chip through the first chip interface pin. The second nonvolatile memory chip includes a second chip interface pin configured to receive the first self termination signal and a second first chip enable interface circuit connected to the second chip interface pin. The second nonvolatile memory chip is configured to be self-enabled based on the first self termination signal from the first nonvolatile memory chip and is configured to perform a second DMA operation to transmit a second read data from the second memory cell array to the storage controller based on a second data output command. The second nonvolatile memory chip is configured to receive the second data output command from the storage controller during the first nonvolatile memory chip performing the first DMA operation.

Accordingly, in the storage device according to example implementations, the first nonvolatile memory chip may perform a first DMA operation to output a first read data to the storage controller based on a first data output command, may internally generate the self termination signal indicating that the first DMA operation is completed based on address and may transfer the self termination signal to the second nonvolatile memory chip. The second nonvolatile memory chip may be self-enabled based on the self termination signal provided from the first nonvolatile memory device and may perform a second DMA operation (associated with a second data output command) to output a second read data to the storage controller without a selection chip enable command from the storage controller. Therefore, the nonvolatile memory chips may perform DMA operations successively without a selection chip enable command and a selection chip termination command from the storage controller, and thus may reduce I/O overhead.

At least some of the above and other features of the invention are set out in the claims.

### BRIEF DESCRIPTION OF THE DRAWINGS

Illustrative, non-limiting example implementations will be more clearly understood from the following detailed description in conjunction with the accompanying drawings.
FIG. 1 is a block diagram illustrating a storage device according to example implementations.
FIG. 2 is a block diagram illustrating an example of the storage controller in the storage device of FIG. 1 according to example implementations.
FIG. 3 illustrates a connection example of the storage controller and one of the plurality of nonvolatile memory device in the storage device of FIG. 1 according to example implementations.
FIG. 4 is a block diagram illustrating an example of one of the plurality of nonvolatile memory devices in the storage device of FIG. 1 according to example implementations.
FIG. 5 is a block diagram illustrating an example of a CEI circuit in the nonvolatile memory device of FIG. 4 according to example implementations.
FIG. 6 is a circuit diagram illustrating a memory plane configuration in the nonvolatile memory device of FIG. 4 according to example implementations.
FIG. 7 schematically illustrates a structure of the nonvolatile memory device of FIG. 4 according to example implementations.
FIG. 8 is a block diagram illustrating an example of the memory plane in FIG. 4 according to example implementations.
FIG. 9 is a circuit diagram illustrating one of the memory blocks of FIG. 8.
FIG. 10 illustrates an example of a structure of a cell string CS in the memory block of FIG. 9.
FIG. 11 is a schematic diagram of a connection of the memory plane to the page buffer circuit in FIG. 4, according to example implementations.
FIG. 12 illustrates a page buffer in detail according to example implementations.
FIG. 13 illustrates four nonvolatile memory devices (nonvolatile memory chips) in the storage media in FIG. 1.
FIG. 14 illustrates CEI circuits in two nonvolatile memory device in FIG. 13.
FIG. 15 is a timing diagram illustrating operation of the nonvolatile memory devices in FIG. 14 according to example implementations.
FIG. 16 illustrates that the nonvolatile memory devices in FIG. 13 perform DMA operations successively.
FIG. 17 illustrates an example operation of the nonvolatile memory device of FIG. 4 according to example implementations.
FIG. 18 is a block diagram illustrating an example of the control circuit in the nonvolatile memory device of FIG. 4 according to example implementations.
FIG. 19 is a block diagram illustrating an example of the voltage generator in the nonvolatile memory device of FIG. 4 according to example implementations.
FIG. 20 is a block diagram illustrating an example of the address decoder in the nonvolatile memory device of FIG. 3 according to example implementations.
FIG. 21 is a flowchart illustrating an example operation of the nonvolatile memory device.
FIG. 22 is a ladder diagram illustrating an example operation of the nonvolatile memory device, according to example implementations.
FIG. 23 is a block diagram illustrating an electronic system including a semiconductor device according to some example implementations.

### DETAILED DESCRIPTION

Various example implementations will be described more fully hereinafter with reference to the accompanying drawings, in which some example implementations are shown.

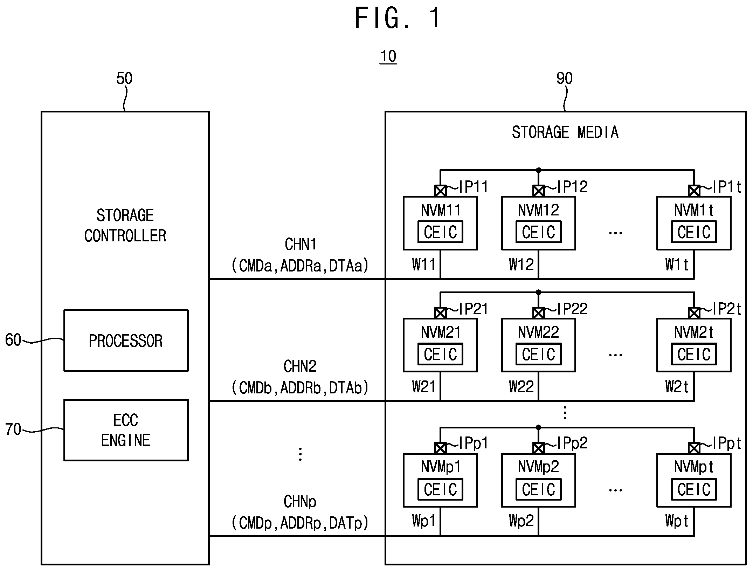

FIG. 1 is a block diagram illustrating a storage device according to example implementations.

Referring to FIG. 1, a storage device 10 may include a storage controller 50 and a storage media 90. The storage device 10 may support a plurality of channels CHN1, CHN2, ..., CHNp (hereinafter CHN1 to CHNp), and the storage media 90 may be connected to the storage controller 50 through the plurality of channels CHN1 to CHNp.

The storage media 90 may include a plurality of nonvolatile memory devices NVM11, NVM12, ..., NVM1t, NVM21, NVM22, ..., NVM2t, NVMp1, NVMp2, ..., NVMpt (hereinafter NVM11 to NVMpt, and t is an integer greater than two). Each of the nonvolatile memory devices NVM11 to NVMpt may be referred to as a nonvolatile memory chip.

Each of the nonvolatile memory devices NVM11 to NVMpt may be connected to one of the plurality of media channels CHN1 to CHNp through a way corresponding thereto. For instance, the nonvolatile memory devices NVM11 to NVM1t may be connected to the first media channel CHN1 through ways W11, W12, ..., W1t, the nonvolatile memory devices NVM21 to NVM2t may be connected to the second media channel CHN2 through ways W21, W22, ..., W2t, and the nonvolatile memory devices NVMp1 to NVMpt may be connected to the p-th media channel CHNp through ways Wp1, Wp2, ..., Wpt. In some example implementations, each of the nonvolatile memory devices NVM11 to NVMpt may be implemented as an arbitrary memory unit that may operate according to an individual command from the storage controller 50. For example, each of the nonvolatile memory devices NVM11 to NVMpt may be implemented as a chip or a die, but example implementations are not limited thereto.

The storage controller 50 may transmit and receive signals to and from the storage media 90 through the plurality of media channels CHN1 to CHNp. For example, the storage controller 50 may transmit commands CMDa, CMDb, ..., CMDp, addresses ADDRa, ADDRb, ..., ADDRp and data DTAa, DTAb, ..., DTAp to the storage media 90 through the media channels CHN1 to CHNp or may receive the DTAa to DTAp from the storage media 90.

The storage controller 50 may select one of the nonvolatile memories NVM11 to NVMpt, which is connected to each of the media channels CHN1 to CHNp, by using a corresponding one of the media channels CHN1 to CHNp, and may transmit and receive signals to and from the selected nonvolatile memory device.

The storage controller 50 may transmit and receive signals to and from the storage media 90 in parallel through different media channels.

The storage controller 50 may communicate with an external host according to universal flash storage (UFS) standards.

In example implementations, each of the storage controller 50 and the storage media 90 may be provided with the form of a chip, a package, or a module. Alternatively, the storage controller 50 and the storage media 90 may be mounted into one of various packages and may be provided with a storage device such as a memory card.

Each of the nonvolatile memory devices NVM11, NVM12, ..., NVM1t coupled to the storage channel CHN1 among the plurality of nonvolatile memory devices NVM11 to NVMpt may include a chip enable interface circuit CEIC and respective one of chip interface pins IP11, IP12, ..., IP1t and the nonvolatile memory devices NVM11, NVM12, ..., NVM1t may be connected together through the interface pins IP11, IP12, ..., IP1t. A first nonvolatile memory device NVM11 among the nonvolatile memory devices NVM11, NVM12, ..., NVM1t may perform a first direct memory access (DMA) operation to transmit a first read data to the storage controller 50, in response to a first data output command from the storage controller 50, may internally generate a self termination signal indicating that the first DMA operation is completed based on an address and may provide the self termination signal to the nonvolatile memory devices NVM12, ..., NVM1t through the chip interface pin IP11. A second nonvolatile memory device receiving a second data output command, among the nonvolatile memory devices NVM12, ..., NVM1t, may be self-enabled based on the self termination command and may perform a second DMA operation associated with the second data output command without a selection chip enable command from the storage controller 50. The nonvolatile memory devices NVM11, NVM12, ..., NVM1t may reduce input/output overhead by performing DMA operation successively without a selection chip termination command and a selection chip enable command.

Similarly, each of the nonvolatile memory devices NVM21, NVM22, ..., NVM2t coupled to the storage channel CHN2 among the plurality of nonvolatile memory devices NVM11 to NVMpt may include a chip enable interface circuit CEIC and respective one of chip interface pins IP21, IP22, ..., IP2t and the nonvolatile memory devices NVM21, NVM22, ..., NVM2t may be connected together through the interface pins IP21, IP22, ..., IP2t. Each of the nonvolatile memory devices NVMp1, NVMp2, ..., NVMpt coupled to the storage channel CHNp among the plurality of nonvolatile memory devices NVM11 to NVMpt may include a chip enable interface circuit CEIC and respective one of chip interface pins IPp1, IPp2, ..., IPpt and the nonvolatile memory devices NVMp1, NVMp2, ..., NVMpt may be connected together through the interface pins IPp1, IPp2, ..., IPpt. The nonvolatile memory devices NVM21, NVM22, ..., NVM2t and the nonvolatile memory devices NVMp1, NVMp2, ..., NVMpt may operate similarly with the nonvolatile memory devices NVM11, NVM12, ..., NVM1t.

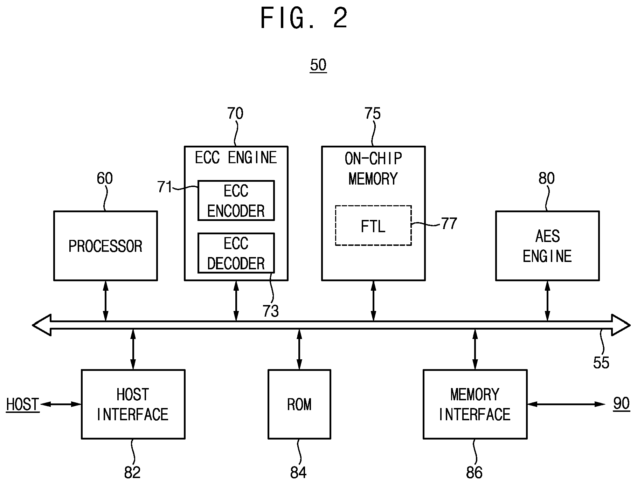

The storage controller 50 may include a processor 60 and an error correction code (ECC) engine 70. Operations of the processor 60 and the ECC engine 70 will be described with reference to FIG. 2.

FIG. 2 is a block diagram illustrating an example of the storage controller in the storage device of FIG. 1 according to example implementations.

Referring to FIG. 2, the storage controller 50 may include the processor 60, the ECC engine 70, an on-chip memory 75, an advanced encryption standard (AES) engine 80, a host interface 82, a ROM 84 and a memory interface 86 which are connected via a bus 55.

The processor 60 may control an overall operation of the storage controller 50. The processor 60 may control the ECC engine 70, the on-chip memory 75, the AES engine 80, the host interface 82, the ROM 84 and the memory interface 86. The processor 60 may include one or more cores (e.g., a homogeneous multi-core or a heterogeneous multi-core). The processor 60 may be or include, for example, at least one of a central processing unit (CPU), an image signal processing unit (ISP), a digital signal processing unit (DSP), a graphics processing unit (GPU), a vision processing unit (VPU), and a neural processing unit (NPU). The processor 60 may execute various application programs (e.g., a flash translation layer (FTL) 77 and firmware) loaded onto the on-chip memory 75.

The on-chip memory 75 may store various application programs that are executable by the processor 60. The on-chip memory 75 may operate as a cache memory adjacent to the processor 60. The on-chip memory 80 may store a command, an address, and data to be processed by the processor 60 or may store a processing result of the processor 60. The on-chip memory 75 may be, for example, a storage medium or a working memory including a latch, a register, a static random access memory (SRAM), a dynamic random access memory (DRAM), a thyristor random access memory (TRAM), a tightly coupled memory (TCM), etc.

The processor 60 may execute the FTL 77 loaded onto the on-chip memory 75. The FTL 77 may be loaded onto the on-chip memory 75 as firmware or a program stored in at least one of the plurality of nonvolatile memory devices NVM11 to NVMpt. The FTL 77 may manage mapping between a logical address provided from a host and a physical address of the at least one of the plurality of nonvolatile memory devices NVM11 to NVMpt and may include an address mapping table manager managing and updating an address mapping table. The FTL 77 may further perform a garbage collection operation, a wear leveling operation, and the like, as well as the address mapping described above. The FTL 77 may be executed by the processor 60 for addressing one or more of the following aspects of the at least one of the plurality of nonvolatile memory devices NVM11 to NVMpt: overwrite- or in-place write-impossible, a life time of a memory cell, a limited number of program-erase (PE) cycles, and an erase speed slower than a write speed.

Memory cells of the plurality of nonvolatile memory devices NVM11 to NVMpt may have the physical characteristic that a threshold voltage distribution varies due to causes, such as a program elapsed time, a temperature, program disturbance, read disturbance and etc. For example, data stored at the plurality of nonvolatile memory devices NVM11 to NVMpt becomes erroneous due to the above causes.

The storage controller 50 may utilize a variety of error correction techniques to correct such errors. For example, the storage controller 50 may include the ECC engine 70. The ECC engine 70 may correct errors which occur in the data stored in the plurality of nonvolatile memory devices NVM11 to NVMpt. The ECC engine 70 may include an ECC encoder 71 and an ECC decoder 73. The ECC encoder 71 may perform an ECC encoding operation on data to be stored in the at least one of the plurality of nonvolatile memory devices NVM11 to NVMpt. The ECC decoder 73 may perform an ECC decoding operation on data read from the at least one of the plurality of nonvolatile memory devices NVM11 to NVMpt. The ECC decoder 73 may correct errors in the hard decision data based on the hard decision data and the soft decision data read from the at least one of the plurality of nonvolatile memory devices NVM11 to NVMpt.

The ROM 84 may store a variety of information, needed for the storage controller 50 to operate, in firmware.

The AES engine 80 may perform at least one of an encryption operation and a decryption operation on data input to the storage controller 50 by using a symmetric-key algorithm. Although not illustrated in detail, the AES engine 80 may include an encryption module and a decryption module. For example, the encryption module and the decryption module may be implemented as separate modules. For another example, one module capable of performing both encryption and decryption operations may be implemented in the AES engine 90.

The storage controller 50 may communicate with a host through the host interface 82. For example, the host interface 82 may include Universal Serial Bus (USB), Multimedia Card (MMC), embedded-MMC, peripheral component interconnection (PCI), PCI-express, Advanced Technology Attachment (ATA), Serial-ATA, Parallel-ATA, small computer small interface (SCSI), enhanced small disk interface (ESDI), Integrated Drive Electronics (IDE), Mobile Industry Processor Interface (MIPI), Nonvolatile memory express (NVMe), Universal Flash Storage (UFS), and etc. The storage controller 50 may communicate with the storage media 90 through the memory interface 86. The memory interface 86 may be referred to as a storage interface.

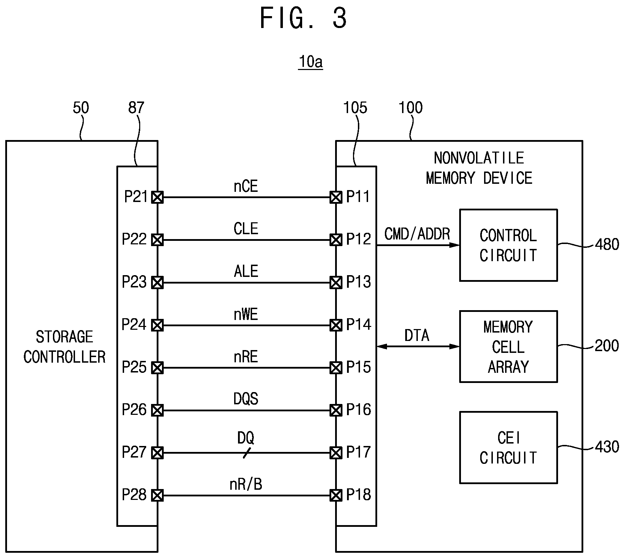

FIG. 3 illustrates a connection example of the storage controller and one of the plurality of nonvolatile memory devices in the storage device of FIG. 1 according to example implementations.

Referring to FIG. 3, a storage device 10a may include a nonvolatile memory device 100 and a storage controller 50. FIG. 3 illustrates an interface between the nonvolatile memory device 100 and the storage controller 50 in detail.

The nonvolatile memory device 100 may include first to eighth pins P11, P12, P13, P14, P15, P16, P17 and P18, an interface circuit 105, a control logic circuit 480, a memory cell array 200 and a chip enable interface (CEI) circuit 430. The interface circuit 105 may be referred to as a first interface circuit or a memory interface circuit.

The interface circuit 105 may receive a chip enable signal nCE from the storage controller 50 through the first pin P11. The interface circuit 105 may transmit and receive signals to and from the storage controller 50 through the second to eighth pins P12 to P18 in response to the chip enable signal nCE. For example, when the chip enable signal nCE is in an enable state (e.g., a low level), the interface circuit 105 may transmit and receive signals to and from the storage controller 50 through the second to eighth pins P12 to P18.

The interface circuit 105 may receive a command latch enable signal CLE, an address latch enable signal ALE and a write enable signal nWE from the storage controller 50 through the second to fourth pins P12 to P14. The interface circuit 105 may receive a data signal DQ from the storage controller 50 through the seventh pin P17 or may transmit the data signal DQ to the storage controller 50. A command CMD, an address ADDR and data DTA may be transmitted via the data signal DQ. For example, the data signal DQ may be transmitted through a plurality of data signal lines. In this case, the seventh pin P17 may include a plurality of pins respectively corresponding to a plurality of data signals DQ(s).

The interface circuit 105 may obtain the command CMD from the data signal DQ, which is received in an enable section (e.g., a high-level state) of the command latch enable signal CLE based on toggle time points of the write enable signal nWE. The interface circuit 105 may obtain the address ADDR from the data signal DQ, which is received in an enable section (e.g., a high-level state) of the address latch enable signal ALE based on the toggle time points of the write enable signal nWE.

In some example implementations, the write enable signal nWE may be maintained at a static state (e.g., a high level or a low level) and may toggle between the high level and the low level. For example, the write enable signal nWE may toggle in a section in which the command CMD or the address ADDR is transmitted. Thus, the interface circuit 105 may obtain the command CMD or the address ADDR based on the toggle time points of the write enable signal nWE.

The interface circuit 105 may receive a read enable signal nRE from the storage controller 50 through the fifth pin P15. The interface circuit 105 may receive a data strobe signal DQS from the storage controller 50 through the sixth pin P16 or may transmit the data strobe signal DQS to the storage controller 50.

In a data output operation of the nonvolatile memory device 100, the interface circuit 105 may receive the read enable signal nRE, which toggles through the fifth pin P15, before outputting the data DTA. The interface circuit 105 may generate the data strobe signal DQS, which toggles based on the toggling of the read enable signal nRE. For example, the interface circuit 105 may generate the data strobe signal DQS, which starts toggling after a predetermined delay (e.g., tDQSRE), based on a toggling start time of the read enable signal nRE. The interface circuit 105 may transmit the data signal DQ including the data DTA based on a toggle time point of the data strobe signal DQS. Thus, the data DTA may be aligned with the toggle time point of the data strobe signal DQS and may be transmitted to the storage controller 50.

In a data input operation of the nonvolatile memory device 100, when the data signal DQ including the data DTA is received from the storage controller 50, the interface circuit 105 may receive the data strobe signal DQS, which toggles, along with the data DTA from the storage controller 50. The interface circuit 105 may obtain the data DTA from the data signal DQ based on toggle time points of the data strobe signal DQS. For example, the interface circuit 105 may sample the data signal DQ at rising and falling edges of the data strobe signal DQS and may obtain the data DTA.

The interface circuit 105 may transmit a ready/busy signal nR/B to the storage controller 50 through the eighth pin P18. The interface circuit 105 may transmit state information of the nonvolatile memory device 100 through the ready/busy signal nR/B to the storage controller 50. When the nonvolatile memory device 100 is in a busy state (e.g., when operations are being performed in the nonvolatile memory device 100), the interface circuit 105 may transmit the ready/busy signal nR/B indicating the busy state to the storage controller 50. When the nonvolatile memory device 100 is in a ready state (e.g., when operations are not performed or are completed in the nonvolatile memory device 100), the interface circuit 105 may transmit the ready/busy signal nR/B indicating the ready state to the storage controller 50.

The control circuit 480 may control overall operations of the nonvolatile memory device 100. The control circuit 480 may receive the command CMD and the address ADDR obtained from the interface circuit 105. The control circuit 480 may generate control signals for controlling other components of the nonvolatile memory device 100 in response to the received command CMD and the received address ADDR. For example, the control circuit 480 may generate various control signals for programming the data DTA to the memory cell array 200 or for reading the data DTA from the memory cell array 200.

The memory cell array 200 may store the data DTA obtained from the interface circuit 105, under the control of the control circuit 480. The memory cell array 200 may output the stored data DTA to the interface circuit 105 under the control of the control circuit 480.

The memory cell array 200 may include a plurality of nonvolatile memory cells.

The CEI circuit 430 may generate a self termination signal indicating that a DMA operation is completed based on an address and may transfer the self termination signal to another nonvolatile memory device through a chip interface pin. As used herein, generating a signal may, in some examples of the present disclosure, include activating the signal, where activating the signal may refer to changing the signal from a first level to a second level. The first level can be associated with the deactivated state of the signal, while the second level can be associated with the activated state of the signal. It is to be noted that, in some other examples, generating a signal may not include activating the signal.

The storage controller 50 may include first to eighth pins P21, P22, P23, P24, P25, P26, P27 and P28 and an interface circuit 87. The interface circuit 87 may be referred to as a second interface circuit or a controller interface circuit. The interface circuit 87 may correspond to the memory interface 86 in FIG. 2. The first to eighth pins P21 to P28 may correspond to the first to eighth pins P11 to P18 of the nonvolatile memory device 100, respectively.

The interface circuit 87 may transmit the chip enable signal nCE to the nonvolatile memory device 100 through the first pin P21. The interface circuit 87 may transmit and receive signals to and from the nonvolatile memory device 100, which is selected by the chip enable signal nCE, through the second to eighth pins P22 to P28.

The interface circuit 87 may transmit the command latch enable signal CLE, the address latch enable signal ALE and the write enable signal nWE to the nonvolatile memory device 100 through the second to fourth pins P22 to P24. The interface circuit 87 may transmit or receive the data signal DQ to and from the nonvolatile memory device 100 through the seventh pin P27.

The interface circuit 87 may transmit the data signal DQ including the command CMD or the address ADDR to the nonvolatile memory device 100 along with the write enable signal nWE, which toggles. The interface circuit 87 may transmit the data signal DQ including the command CMD to the nonvolatile memory device 100 by transmitting the command latch enable signal CLE having an enable state. Also, the interface circuit 87 may transmit the data signal DQ including the address ADDR to the nonvolatile memory device 100 by transmitting the address latch enable signal ALE having an enable state.

The interface circuit 87 may transmit the read enable signal nRE to the nonvolatile memory device 100 through the fifth pin P25. The interface circuit 87 may receive or transmit the data strobe signal DQS from or to the nonvolatile memory device 100 through the sixth pin P26.

The interface circuit 87 may receive the ready/busy signal nR/B from the nonvolatile memory device 100 through the eighth pin P28. The interface circuit 87 may determine state information of the nonvolatile memory device 100 based on the ready/busy signal nR/B.

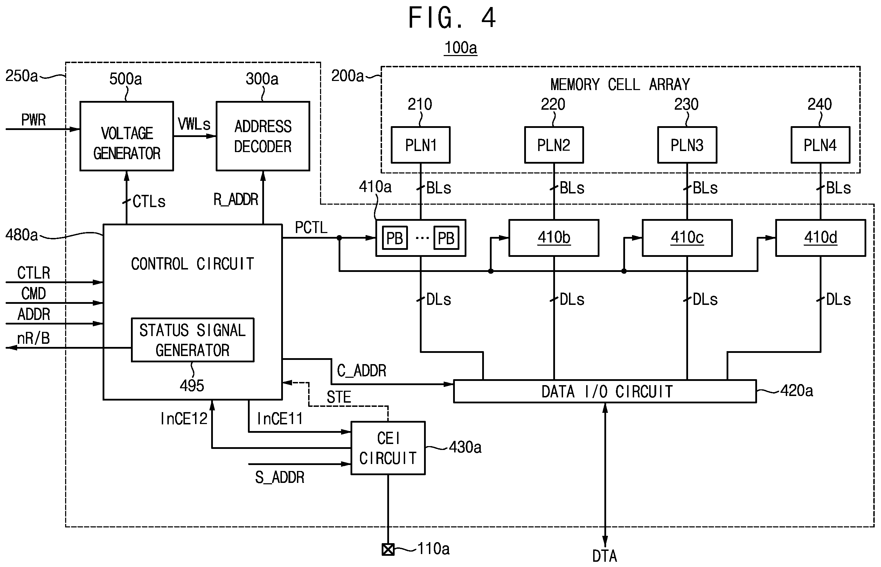

FIG. 4 is a block diagram illustrating an example of one of the plurality of nonvolatile memory devices in the storage device of FIG. 1 according to example implementations.

Referring to FIG. 4, a nonvolatile memory device 100a may include a memory cell array 200a and a peripheral circuit 250a.

The memory cell array 200a may include a PLN1 (210), PLN2 (220), PLN3 (230) and PLN4 (240) corresponding to different bit-lines.

The peripheral circuit 250a may include a plurality of page buffer circuits 410a, 410b, 410c and 410d, a data input/output (I/O) circuit 420a, a CEI circuit 430a, a control circuit 480a, a voltage generator 500a and an address decoder 300a.

The memory cell array 200a may be coupled to the address decoder 300 through a string selection line SSL, a plurality of word-lines WLs, and a ground selection line GSL. Each of the plurality of page buffer circuits 410a, 410b, 410c and 410d may be connected to a respective one of the plurality of memory planes 210, 220, 230 and 240 through corresponding bit-lines BLs. The plurality of memory planes 210, 220, 230 and 240 may include a plurality of nonvolatile memory cells coupled to the plurality of word-lines WLs and the plurality of bit-lines BLs.

Each of the plurality of memory planes 210, 220, 230 and 240 may include a plurality of memory blocks, and each of the memory blocks may have a three-dimensional (3D) structure. Each of the memory blocks may include a plurality of (vertical) cell strings and each of the cell strings includes a plurality of memory cells stacked with respect to each other. Each of the plurality of memory planes 210, 220, 230 and 240 may be referred to a first memory plane 210, a second memory plane 220, a third memory plane 230 and a fourth memory plane 240.

Each of the plurality of page buffer circuits 410a, 410b, 410c and 410d may be connected to the data I/O circuit 420a through corresponding data lines DLs.

The control circuit 480a may receive a command CMD, an address ADDR, and a control signal CTRL from the storage controller 50 and may control an erase loop, a program loop and a read operation of the nonvolatile memory device 100 based on the command CMD, the address ADDR, and the control signal CTRL. The program loop may include a program operation and a program verification operation and the erase loop may include an erase operation and an erase verification operation.

In example implementations, the control circuit 480a may generate control signals CTLs, which are used for controlling the voltage generator 500a, based on the command CMD, may provide the control signals CTLs to the voltage generator 500a, may generate a page buffer control signal PCTL for controlling the plurality of page buffer circuits 410a, 410b, 410c and 410d, and may provide the page buffer control signal PCTL to the plurality of page buffer circuits 410a, 410b, 410c and 410d,

In addition, the control circuit 480a may generate a row address R_ADDR and a column address C_ADDR based on the address signal ADDR. The control circuit 480a may provide the row address R_ADDR to the address decoder 300a and may provide the column address C_ADDR to the data I/O circuit 420a. The control circuit 480a may include a status generator 495 and the status generator 495 may generate the read/busy signal (e.g., a status signal) nR/B indicating an operating status of the nonvolatile memory device 100.

The address decoder 300a may be coupled to the memory cell array 200a through the string selection line SSL, the plurality of word-lines WLs, and the ground selection line GSL. During program operation or read operation, the address decoder 300a may determine one of the plurality of word-lines WLs as a selected word-line based on the row address R_ADDR and may determine the rest of the plurality of word-lines WLs except the selected word-line as unselected word-lines.

The voltage generator 500a may generate word-line voltages VWLs associated with operations of the nonvolatile memory device 100a using a power PWR provided from the storage controller 50 based on control signals CTLs from the control circuit 480a. The word-line voltages VWLs may include a program voltage, a read voltage, a pass voltage, an erase verification voltage, or a program verification voltage. The word-line voltages VWLs may be applied to the plurality of word-lines WLs through the address decoder 300a.

For example, during the erase operation, the voltage generator 500a may apply erase voltage to a channel of cell strings of a selected memory block and may apply a ground voltage to all word-lines of the selected memory block. During the erase verification operation, the voltage generator 500a may apply erase verification voltage to all word-lines of the selected memory block or may apply the erase verification voltage to the word-lines of the selected memory block by word-line basis.

For example, during the program operation, the voltage generator 500a may apply a program voltage to the selected word-line and may apply a program pass voltage to the unselected word-lines. In addition, during the program verification operation, the voltage generator 500a may apply a program verification voltage to the selected word-line and may apply a verification pass voltage to the unselected word-lines. In addition, during the read operation, the voltage generator 500a may apply a read voltage to the selected word-line and may apply a read pass voltage to the unselected word-lines.

Each of the plurality of page buffer circuits 410a, 410b, 410c and 410d may include a plurality of page buffers PB. Each of the plurality of page buffer circuits 410a, 410b, 410c and 410d may temporarily store data to be programmed in a selected page or data read out from the selected page of the memory cell array 200a.

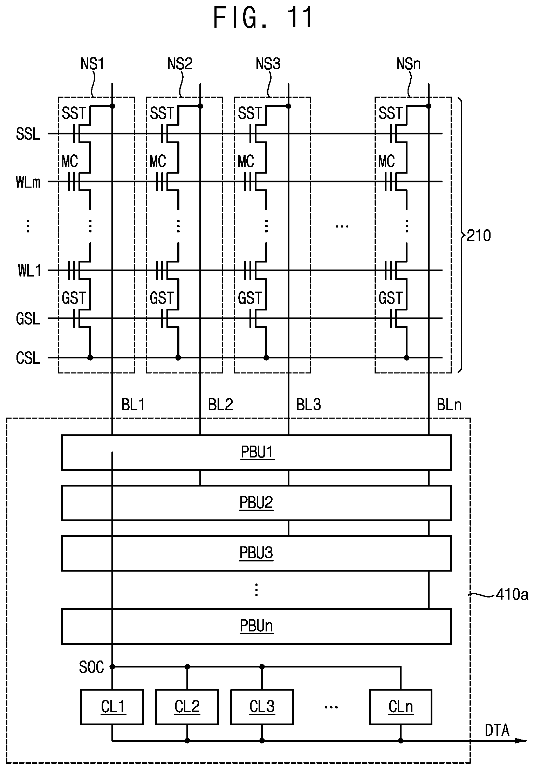

In example implementations, page buffer units included in each of the plurality of page buffers PB (for example, first through n-th page buffer units PBU1 through PBUn in FIG. 11) and cache latches included in each of the plurality of page buffers PB (for example, first through n-th cache latches CL1 through CLn in FIG. 11) may be apart from each other, and have separate structures. Accordingly, the degree of freedom of wirings on the page buffer units may be improved, and the complexity of a layout may be reduced. In addition, because the cache latches are adjacent to data I/O lines, the distance between the cache latches and the data I/O lines may be reduced, and thus, data I/O speed may be improved.

The control circuit 480a may control operation of the nonvolatile memory device 100a based on the control signal CTRL and the command CMD. The control circuit 480a, in response to a first read command, may perform a first read operation by sensing a read data stored in one of the plurality of memory planes 210, 220, 230 and 240 and may perform a first DMA operation to output the sensed data (e.g., a first read data) to the storage controller 50 through the data I/O circuit 420a, based on a first data output command from the storage controller 50.

The CEI circuit 430a, in a transmission mode, may receive a start address S_ADDR associated with a starting of the first DMA operation, may generate a self termination signal indicating that the first DMA operation is completed based on the start address S_ADDR and may transfer the self termination signal to another nonvolatile memory device through a chip interface pin 110a. The CEI circuit 430a may provide a self termination signal STE to the control circuit 480a.

The CEI circuit 430a, in a reception mode, may receive a self termination signal from another nonvolatile memory device through the chip interface pin 110a, may generate an internal chip enable signal InCE12 that self-enables the nonvolatile memory device 100a based on the self termination signal and may provide the internal chip enable signal InCE12 to the control circuit 480a.

The control circuit 480a may receive an chip enable signal as a portion of the control signal CTRL, may activate an internal chip enable signal InCE11 with a logic low level and may provide the CEI circuit 430a with the internal chip enable signal InCE11 that is activated.

The CEI circuit 430a may operate in the transmission mode based on the internal chip enable signal InCE11 being activated and may operate in the transmission mode based on the internal chip enable signal InCE11 being activated.

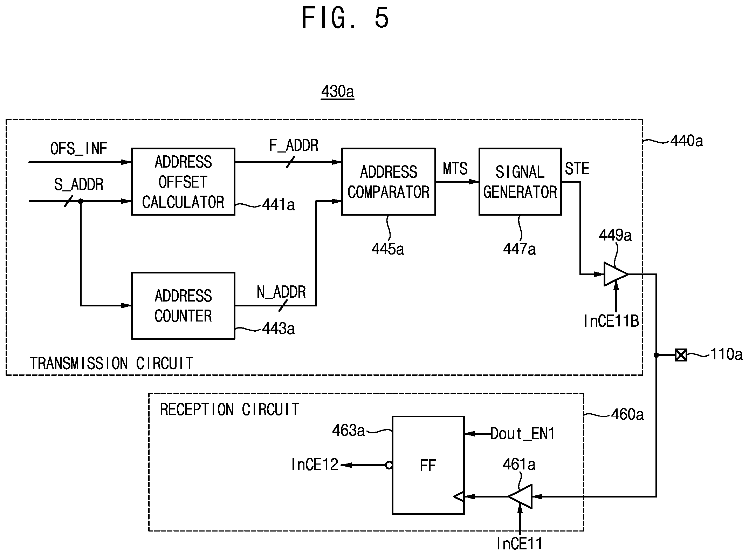

FIG. 5 is a block diagram illustrating an example of a CEI circuit in the nonvolatile memory device of FIG. 4 according to example implementations.

Referring to FIG. 5, the CEI circuit 430a may include a transmission circuit 440a and a reception circuit 460a. The transmission circuit 440a and the reception circuit 460a may be connected to the chip interface pin 110a.

The transmission circuit 440a may operate (may be enabled) in the transmission mode, may detect a completion of the first DMA operation of the nonvolatile memory device 100a, may generate a self termination signal STE indicating that the first DMA operation is completed and may transfer the self termination signal STE to another nonvolatile memory device through the chip interface pin 110a.

The reception circuit 460a may operate (may be enabled) in the reception mode, may receive a self termination signal provided from another nonvolatile memory device through the chip interface pin 110a, may generate an internal chip enable signal InCE12 associated with self-enabling of the nonvolatile memory device 100a and may provide the internal chip enable signal InCE12 to the control circuit 480a in FIG. 4.

The transmission circuit 440a may include an address offset calculator 441a, an address counter 443a, an address comparator 445a, a signal generator 447a and a buffer 449a.

The address offset calculator 441a may calculate a final address F_ADDR of a first read data (read from the memory cell array 200a in FIG. 4) based on a first start address S_ADDR and an offset information OFS_INF associated with a size of the first read data and may provide the final address F_AADDR to the address comparator 445a.

The address counter 443a may generate a normal address N_ADDR that sequentially increments from the first start address S_ADDR by performing a counting operation based on the first start address S_ADDR and may provide the normal address N_ADDR to the address comparator 445a. The address counter 443a may stop the counting operation when the normal address N_ADDR reaches a predetermined address (for example, the final address F_ADDR).

The address comparator 445a may generate a match signal MTS by comparing the final address F_ADDR and the normal address N_ADDR. The address comparator 445a may output the match signal MTS with a logic high level based on the normal address N_ADDR matching the final address F_ADDR. The address counter 443a may stop the counting operation when the normal address N_ADDR reaches the final address F_ADDR based on the match signal MTS with a logic high level. The address counter 443a may receive the match signal MTS with a logic high level (not illustrated) and stops the counting operation until the address counter 443a receives a new start address.

The signal generator 447a may generate the self termination signal STE based on the match signal MTS and provide the self termination signal STE to the buffer 449a. The signal generator 447a may output the self termination signal STE transitioning to a logic high level based on the match signal MTS transitioning to a logic high level.

The buffer 449a may receive the self termination signal STE, may selectively provide the self termination signal STE to the chip interface pin 110a as a termination information, based on an inverted internal chip enable signal InCE11b obtained by inverting the internal chip enable signal InCE11. The internal chip enable signal InCE11 may be generated based on the chip enable signal nCE. The buffer 449a may be enabled when the inverted internal chip enable signal InCE11b is in a logic high level (that is, when the internal chip enable signal InCE11 is in a logic low level), and may transfer the self termination signal STE to the chip interface pin 110a. On the other hand, the buffer 449a may be disabled when the inverted internal chip enable signal InCE11b in a logic low level (that is, when the internal chip enable signal InCE11 is in a logic high level). When the buffer 449a is disabled, it may not transfer the self termination signal STE to the chip interface pin 110a. Therefore, by enabling or disabling the buffer 449a based on whether the inverted internal chip enable signal InCE11b is in the logic high level, the buffer 449a may selectively provide the self termination signal STE to the chip interface pin 110a.

The reception circuit 460a may include a buffer 461a and a flip-flop FF 463a.

The buffer 461a may be connected to the chip interface pin 110, may receive the self termination signal provided from another nonvolatile memory device may selectively provide the self termination signal to the flip-flop 463a based on the internal chip enable signal InCE11. The buffer 461a may be enabled when the internal chip enable signal InCE11 is in a logic high level and may provide the flip-flop 463a with the self termination signal provided from another nonvolatile memory device. The buffer 461a may be disabled when the internal chip enable signal InCE11 is in a logic low level. When the buffer 461a is disabled, it may not provide the flip-flop 463a with the self termination signal. Therefore, by enabling or disabling the buffer 461a based on whether internal chip enable signal InCE11 is in a logic high level, the buffer 461a may selectively provide the self termination signal to the flip-flop 463a.

The flip-flop 463a may generate the internal chip enable signal InCE12 by latching and inverting a data output enable signal Dout_EN1 based on an output of the buffer 461a and may provide the internal chip enable signal InCE12 to the control circuit 480a in FIG. 4. The control circuit 480a may self-enable the nonvolatile memory device 100a based on transitioning of the internal chip enable signal InCE12.

The flip-flop 463a may generate the internal chip enable signal InCE12 with a logic low level by inverting the data output enable signal Dout_EN1 with a logic high level based on the output of the buffer 461a being in a logic high level.

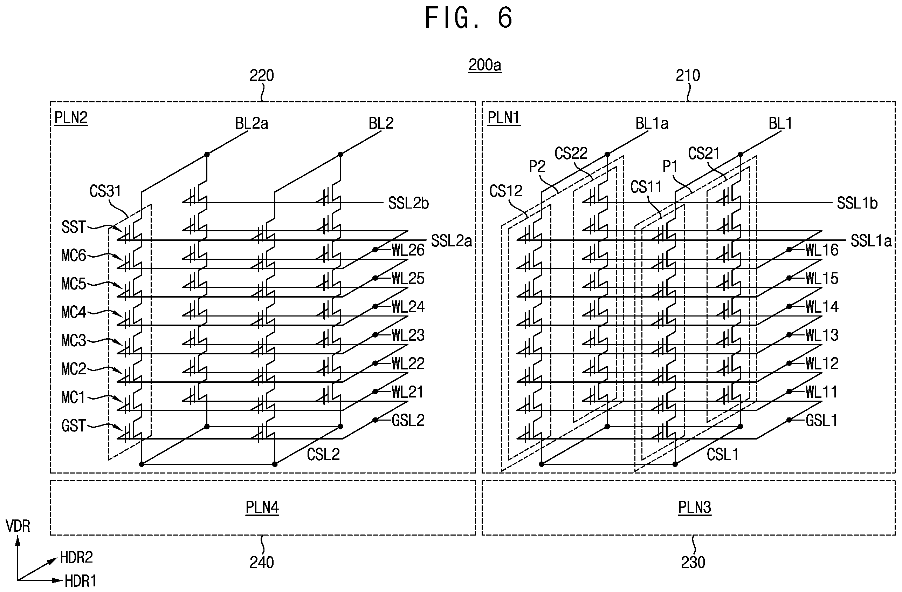

FIG. 6 is a circuit diagram illustrating a memory plane configuration in the nonvolatile memory device of FIG. 4 according to example implementations.

Referring to FIG. 6, the memory cell array 200a including the plurality of memory planes 210, 220, 230 and 240 is illustrated. Each of the plurality of memory planes 210, 220, 230 and 240 may include a plurality of memory blocks which are formed in a first horizontal direction HDR1, a second horizontal direction HDR2 and a vertical direction VDR, and each of the memory blocks may include a plurality of cell strings. For example, a memory block of the memory plane 210 may include a plurality of cell strings CS11, CS12, CS21, and CS22. In FIG. 4, configuration of each of the memory planes 210 and 220 are illustrated in detail for convenience of explanation, configuration of each of the memory planes 230 and 240 may be substantially the same as the configuration of each of the memory planes 210 and 220.

Each of the memory planes (first and second memory planes) 210 and 220 may include a plurality of memory blocks, and one of the memory blocks may have multiple string selection lines SSL1a and SSL1b to select at least one of the cell strings CS11, CS12, CS21, and CS22. For example, when a selection voltage is applied to a first string selection line SSL1a, the first and second cell strings CS11 and CS12 may be selected. When a selection voltage is applied to a second string selection line SSL1b, third and fourth cell strings CS21 and CS22 may be selected.

In some implementations, the memory planes 210 and 220 may have the same physical structure. For example, like the memory plane 210, the memory plane 220 may include multiple memory blocks and multiple cell strings formed in a memory block of the multiple memory blocks. Also, the memory plane 220 may include multiple string selection lines SSL2a and SSL2b to select at least one of multiple cell strings.

Each of the memory planes 210 and 220 may be coupled to corresponding word-lines and a common source line. The cell strings in the memory plane 210 may be coupled to word-lines WL11~WL16, a ground selection line GSL1 and a common source line CSL1. The cell strings in the memory plane 220 may be coupled to word-lines WL21~WL26, a ground selection line GSL2 and a common source line CSL2.

The memory planes 210 and 220 do not share bit-lines. First bit-lines BL1 and BL1a are coupled to the memory plane 210 exclusively. Second bit-lines BL2 and BL2a are coupled to the memory plane 220 exclusively.

Although FIG. 6 illustrates an example in which each memory plane is connected with two bit-lines and six word-lines, example implementations are not limited to these features. For example, each memory plane may be connected with three or more bit-lines and seven or more word-lines.

Each cell string may include at least one string selection transistor, memory cells, and at least one ground selection transistor. For example, a cell string CS31 of the memory plane 220 may include a ground selection transistor GST, multiple memory cells MC1 to MC6, and a string selection transistor SST successively being perpendicular to a substrate. The remaining cell strings may be formed substantially the same as the cell string CS31.

The memory planes 210 and 220 may include independent string selection lines. For example, string selection lines SSL1a and SSL1b are only connected with the memory plane 210, and string selection lines SSL2a and SSL2b are only connected with the memory plane 220. A string selection line may be used to select cell strings only in a memory plane. Also, cell strings may be independently selected in every memory plane by controlling the string selection lines independently.

For example, cell strings CS11 and CS12 may be independently selected by applying a selection voltage only to first string selection line SSL1a. When the selection voltage is applied to first string selection line SSL1a, string selection transistors of cell strings CS11 and CS12 corresponding to first string selection line SSL1a may be turned on by the selection voltage. At this time, memory cells of the cell strings CS11 and CS12 may be electrically connected with a bit-line. When a non-selection voltage is applied to first string selection line SSL1a, string selection transistors of cell strings CS11 and CS12 corresponding to first string selection line SSL1a are turned off by the non-selection voltage. At this time, memory cells of the cell strings CS11 and CS12 are electrically isolated from a bit-line BL1.

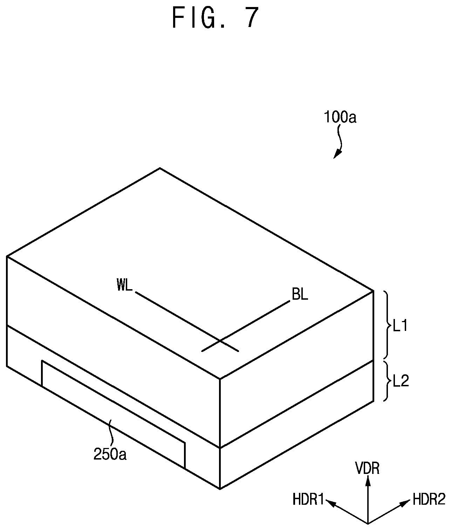

FIG. 7 schematically illustrates a structure of the nonvolatile memory device of FIG. 4 according to example implementations.

Referring to FIG. 7, the nonvolatile memory device 100a may include a first semiconductor layer L1 and a second semiconductor layer L2, and the first semiconductor layer L1 may be stacked in the vertical direction VDR with respect to the second semiconductor layer L2. The second semiconductor layer L2 may be under the first semiconductor layer L1 in the vertical direction VDR, and accordingly, the second semiconductor layer L2 may be close to a substrate.

In example implementations, the memory cell array 200a in FIG. 4 may be formed (or, provided) on the first semiconductor layer L1, and the peripheral circuit 250a in FIG. 4 may be formed (or, provided) on the second semiconductor layer L2. Accordingly, the nonvolatile memory device 100a may have a structure in which the memory cell array 200a is on the peripheral circuit 250a, that is, a cell over periphery (COP) structure. The COP structure may effectively reduce an area in a horizontal direction and improve the degree of integration of the nonvolatile memory device 100a.

In example implementations, the second semiconductor layer L2 may include the substrate, and by forming transistors on the substrate and metal patterns for wiring transistors, the peripheral circuit 250a may be formed in the second semiconductor layer L2. After the peripheral circuit 250a is formed on the second semiconductor layer L2, the first semiconductor layer L1 including the memory cell array 200a may be formed, and the metal patterns for connecting the word-lines WL and the bit-lines BL of the memory cell array 200a to the peripheral circuit 250a formed in the second semiconductor layer L2 may be formed. For example, the word-lines WL may extend in the first horizontal direction HDR1, and the bit-lines BL may extend in the second horizontal direction HDR2.

As the number of stages of memory cells in the memory cell array 200a increases with the development of semiconductor processes, that is, as the number of stacked word-lines WL increases, an area of the memory cell array 200a may decrease, and accordingly, an area of the peripheral circuit 250a may also be reduced. According to an implementation, to reduce an area of a region occupied by the page buffer circuits 410a, 410b, 410c and 410d, each of the page buffer circuits 410a, 410b, 410c and 410d may have a structure in which the page buffer unit and the cache latch are separated from each other, and may connect sensing nodes included in each of the page buffer units commonly to a combined sensing node. This will be explained in detail with reference to FIG. 11.

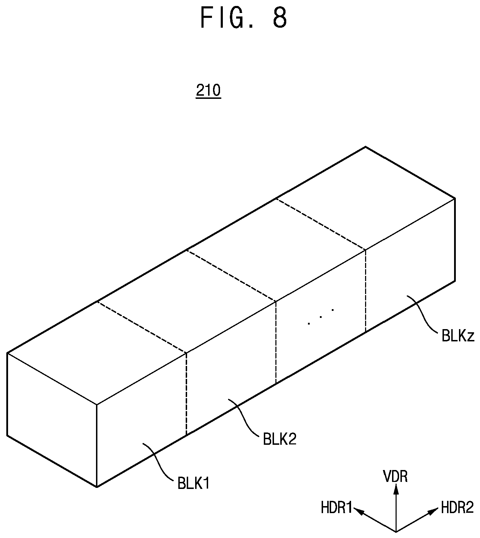

FIG. 8 is a block diagram illustrating an example of the memory plane in FIG. 4 according to example implementations.

Referring to FIG. 8, the memory plane 210 may include a plurality of memory blocks BLK1, BLK2, ..., BLKz which extend along a plurality of directions HDR1, HDR2 and VDR. Here, z is an integer greater than two. In an implementation, the memory blocks BLK1, BLK2, ..., BLKz are selected by the address decoder 300a in FIG. 4. For example, the address decoder 300a may select a memory block corresponding to a block address among the memory blocks BLK1, BLK2, ..., BLKz.

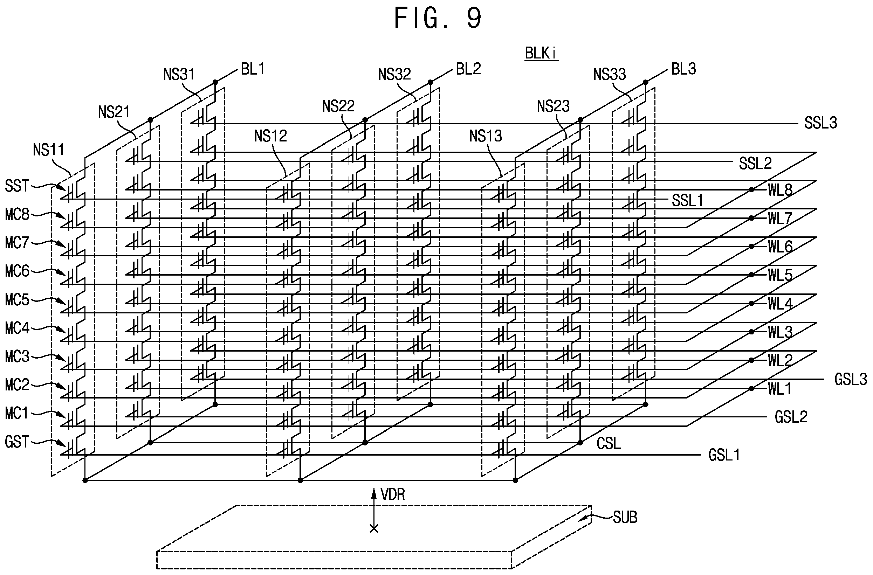

FIG. 9 is a circuit diagram illustrating one of the memory blocks of FIG. 8.

A memory block BLKi of FIG. 8 may be formed on a substrate SUB in a three-dimensional structure (or a vertical structure). For example, a plurality of (memory) cell strings included in the memory block BLKi may be formed in the vertical direction VDR perpendicular to the substrate SUB.

Referring to FIG. 9, the memory block BLKi may include a plurality of cell strings NS11, NS21, NS31, NS12, NS22, NS32, NS13, NS23 and NS33 (hereinafter, represented as NS11 to NS33) coupled between bit-lines BL1, BL2 and BL3 and a common source line CSL. Each of the cell strings NS11 to NS33 may include a string selection transistor SST, a plurality of memory cells MC1, MC2, MC3, MC4, MC5, MC6, MC7 and MC8 (hereinafter represented as MC1 to MC8), and a ground selection transistor GST. In FIG. 9, each of the cell strings NS11 to NS33 is illustrated to include eight memory cells MC1 to MC8. However, present disclosure are not limited thereto. In some example implementations, each of the cell strings NS11 to NS33 may include any number of memory cells.

The string selection transistor SST may be connected to corresponding string selection lines SSL1, SSL2 and SSL3 (hereinafter, represented as SSL1 to SSL3). The plurality of memory cells MC1 to MC8 may be connected to corresponding word-lines WL1 to WL8, respectively. The ground selection transistor GST may be connected to corresponding ground selection lines GSL1, GSL2 and GSL3 (hereinafter, represented as GSL1 to GSL3). The string selection transistor SST may be connected to corresponding bit-lines BL1, BL2 and BL3, and the ground selection transistor GST may be connected to the common source line CSL.

Word-lines (e.g., WL1) having the same height may be commonly connected, and the ground selection lines GSL1 to GSL3 and the string selection lines SSL1 to SSL3 may be separated.

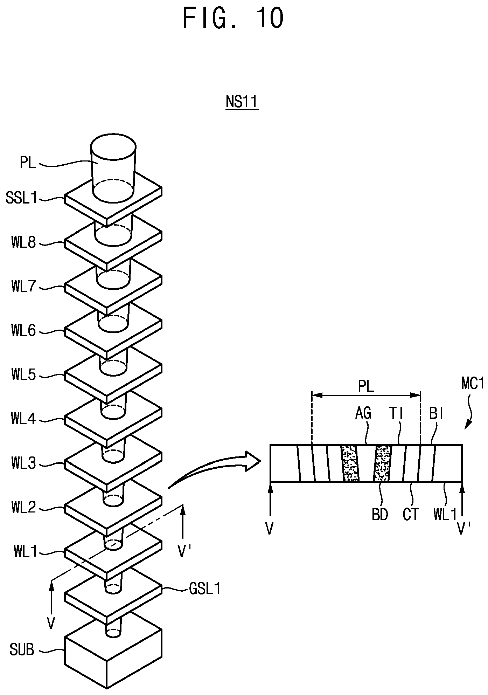

FIG. 10 illustrates an example of a structure of a cell string CS in the memory block of FIG. 9.

Referring to FIGS. 9 and 10, a pillar PL is provided on the substrate SUB such that the pillar PL extends in a direction perpendicular to the substrate SUB to make contact with the substrate SUB. Each of the ground selection line GSL, the word-lines WL1 to WL8, and the string selection lines SSL1 illustrated in FIG. 10 may be formed of a conductive material parallel with the substrate SUB, for example, a metallic material. The pillar PL may be in contact with the substrate SUB through the conductive materials forming the string selection lines SSL, the word-lines WL1 to WL8, and the ground selection line GSL1.

A sectional view taken along a line V-V' is also illustrated in FIG. 10. In some example implementations, a sectional view of a first memory cell MC1 corresponding to a first word-line WL1 is illustrated. The pillar PL may include a cylindrical body BD. An air gap AG may be defined in the interior of the body BD.

The body BD may include P-type silicon and may be an area where a channel will be formed. The pillar PL may further include a cylindrical tunnel insulating layer TI surrounding the body BD and a cylindrical charge trap layer CT surrounding the tunnel insulating layer TI. A blocking insulating layer BI may be provided between the first word-line WL1 and the pillar PL. The body BD, the tunnel insulating layer TI, the charge trap layer CT, the blocking insulating layer BI, and the first word-line WL1 may constitute or be included in a charge trap type transistor that is formed in a direction perpendicular to the substrate SUB or to an upper surface of the substrate SUB. A string selection transistor SST, a ground selection transistor GST, and other memory cells may have the same structure as the first memory cell MC1.

FIG. 11 is a schematic diagram of a connection of the memory plane to the page buffer circuit in FIG. 4, according to example implementations.

Referring to FIG. 11, the memory plane 210 may include first through n-th cell strings NS1, NS2, NS3, ..., NSn (hereinafter, represented as NS1 through NSn), each of the first through n-th cell strings NS1 through NSn may include a ground select transistor GST connected to the ground select line GSL, a plurality of memory cells MC respectively connected to the first through m-th word-lines WL1, ..., WLm (hereinafter, represented as WL1 through WLm), and a string select transistor SST connected to the string select line SSL, and the ground select transistor GST, the plurality of memory cells MC, and the string select transistor SST may be connected to each other in series. In this case, m may be a positive integer.

The page buffer circuit 410 may include first through n-th page buffer units PBU1, PBU2, PBU3, ..., PBUn (hereinafter, represented as PBU1 through PBUn). The first page buffer unit PBU1 may be connected to the first cell string NS1 via the first bit-line BL1, and the n-th page buffer unit PBUn may be connected to the n-th cell string NSn via the n-th bit-line BLn. In this case, greater than 3. For example, n may be 8, and the page buffer circuit 410 may have a structure in which page buffer units of eight stages, or, the first through n-th page buffer units PBU1 through PBUn are in a line. For example, the first through n-th page buffer units PBU1 through PBUn may be in a row in an extension direction of the first through n-th bit-lines BL1 through BLn.

The page buffer circuit 410 may further include first through n-th cache latches CL1, CL2, CL3, ..., CLn (hereinafter, represented as CL1 through CLn) respectively corresponding to the first through n-th page buffer units PBU1 through PBUn. For example, the page buffer circuit 410 may have a structure in which the cache latches of eight stages or the first through n-th cache latches CL1 through CLn in a line. For example, the first through n-th cache latches CL1 through CLn may be in a row in an extension direction of the first through n-th bit-lines BL1 through BLn.

The sensing nodes of each of the first through n-th page buffer units PBU1 through PBUn may be commonly connected to a combined sensing node SOC. In addition, the first through n-th cache latches CL1 through CLn may be commonly connected to the combined sensing node SOC. Accordingly, the first through n-th page buffer units PBU1 through PBUn may be connected to the first through n-th cache latches CL1 through CLn via the combined sensing node SOC. The first through n-th cache latches CL1 through CLn may output the data DTA.

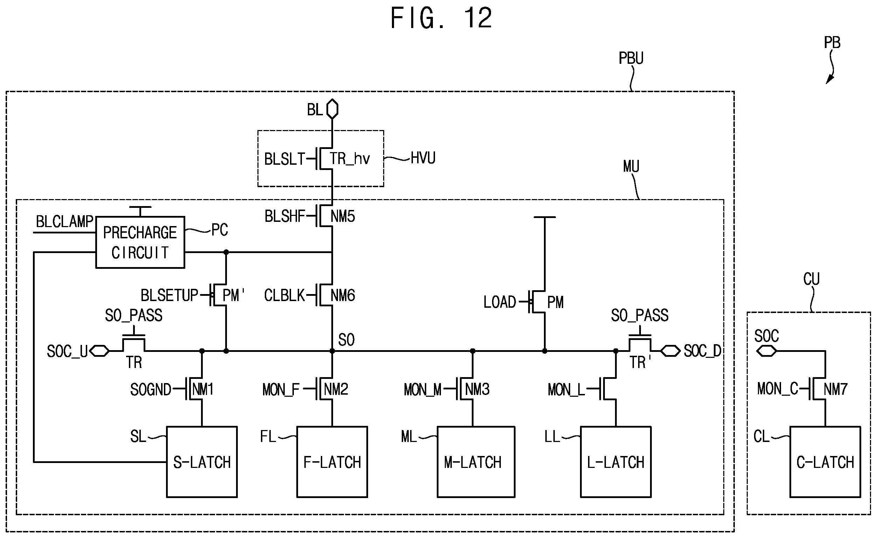

FIG. 12 illustrates a page buffer in detail according to example implementations.

Referring to FIG. 12, the page buffer PB may correspond to an example of the page buffer PB in FIG. 4. The page buffer PB may include a page buffer unit PBU and a cache unit CU. Because the cache unit CU includes a cache latch (C-LATCH) CL, and the C-LATCH CL is connected to a global data line, the cache unit CU may be adjacent to the global data line. Accordingly, the page buffer unit PBU and the cache unit CU may be apart from each other, and the page buffer PB may have a structure in which the page buffer unit PBU and the cache unit CU are apart from each other.

The page buffer unit PBU may include a main unit MU. The main unit MU may include main transistors in the page buffer PB. The page buffer unit PBU may further include a bit-line selection transistor TR_hv that is connected to the bit-line BL and driven by a bit-line selection signal BLSLT. The bit-line select transistor TR_hv may include a high voltage transistor, and accordingly, the bit-line selection transistor TR_hv may be in a different well region from the main unit MU, that is, in a high voltage unit HVU.

The main unit MU may include a sensing latch (S-LATCH) SL, a force latch (F-LATCH) FL, an upper bit latch (M-LATCH) ML and a lower bit latch (L-LATCH) LL. According to an implementation, the S-LATCH SL, the F-LATCH FL, the M-LATCH ML, or the L-LATCH LL may be referred to as main latches or data latches. The main unit MU may further include a precharge circuit PC capable of controlling a precharge operation on the bit-line BL or a sensing node SO based on a bit-line clamping control signal BLCLAMP, and may further include a transistor PM' driven by a bit-line setup signal BLSETUP.

The S-LATCH SL may, during a read or program verification operation, store data stored in a memory cell MC or a sensing result of a threshold voltage of the memory cell MC. In addition, the S-LATCH SL may, during a program operation, be used to apply a program bit-line voltage or a program inhibit voltage to the bit-line BL.

The F-LATCH FL may be used to improve threshold voltage distribution during the program operation. The F-LATCH FL may store force data. After the force data is initially set to '1', the force data may be converted to '0' when the threshold voltage of the memory cell MC enters a forcing region that has a lower voltage than a target region. By utilizing the force data during a program execution operation, the bit-line voltage may be controlled, and the program threshold voltage distribution may be formed narrower.

The M-LATCH ML, the L-LATCH LL, and the C-LATCH CL may be utilized to store data externally input during the program operation, and may be referred to as data latches. When data of 3 bits is programmed in one memory cell MC, the data of 3 bits may be stored in the M-LATCH ML, the L-LATCH LL, and the C-LATCH CL, respectively. Until a program of the memory cell MC is completed, the M-LATCH ML, the L-LATCH LL, and the C-LATCH CL may maintain the stored data. In addition, the C-LATCH CL may receive data read from a memory cell MC during the read operation from the S-LATCH SL, and output the received data to the outside via the global data line.

In addition, the main unit MU may further include first through fourth transistors NM1 through NM4. The first transistor NM1 may be connected between the sensing node SO and the S-LATCH SL, and may be driven by a ground control signal SOGND. The second transistor NM2 may be connected between the sensing node SO and the F-LATCH FL, and may be driven by a forcing monitoring signal MON_F. The third transistor NM3 may be connected between the sensing node SO and the M-LATCH ML, and may be driven by a higher bit monitoring signal MON_M. The fourth transistor NM4 may be connected between the sensing node SO and the L-LATCH LL, and may be driven by a lower bit monitoring signal MON_L.

In addition, the main unit MU may further include fifth and sixth transistors NM5 and NM6 connected to each other in series between the bit-line selection transistor TV_hv and the sensing node SO. The fifth transistor NM5 may be driven by a bit-line shut-off signal BLSHF, and the sixth transistor NM6 may be driven by a bit-line connection control signal CLBLK. In addition, the main unit MU may further include a precharge transistor PM. The precharge transistor PM may be connected to the sensing node SO, driven by a load signal LOAD, and precharge the sensing node SO to a precharge level in a precharge period.

In an implementation, the main unit MU may further include a pair of pass transistors connected to the sensing node SO, or first and second pass transistors TR and TR'. According to an implementation, the first and second pass transistors TR and TR' may also be referred to as first and second sensing node connection transistors, respectively. The first and second pass transistors TR and TR' may be driven in response to a pass control signal SO_PASS. According to an implementation, the pass control signal SO_PASS may be referred to as a sensing node connection control signal. The first pass transistor TR may be connected between a first terminal SOC_U and the sensing node SO, and the second pass transistor TR' may be between the sensing node SO and a second terminal SOC_D.

For example, when the page buffer unit PBU corresponds to the second page buffer unit PBU2 in FIG. 9, the first terminal SOC_U may be connected to one end of the pass transistor included in the first page buffer unit PBU1, and the second terminal SOC_D may be connected to one end of the pass transistor included in the third page buffer unit PBU3. In this manner, the sensing node SO may be electrically connected to the combined sensing node SOC via pass transistors included in each of the third through n-th page buffer units PBU3 through PBUn.

During the program operation, the page buffer PB may verify whether the program is completed in a memory cell selected among the memory cells included in the cell string connected to the bit-line BL. The page buffer PB may store data sensed via the bit-line BL during the program verify operation in the S-LATCH SL. The M-LATCH ML and the L-LATCH LL may be set in which target data is stored according to the sensed data stored in the S-LATCH SL.

For example, when the sensed data indicates that the program is completed, the M-LATCH ML and the L-LATCH LL may be switched to a program inhibit setup for the selected memory cell in a subsequent program loop. The C-LATCH CL may temporarily store input data provided from the outside. During the program operation, the target data to be stored in the C-LATCH CL may be stored in the M-LATCH ML and the L-LATCH LL.

The data latches and the cache latches may be referred to a latch group.

Hereinafter, assuming that signals for controlling elements in the page buffer circuit 410 are included in the page buffer control signal PCTL in FIG. 4.

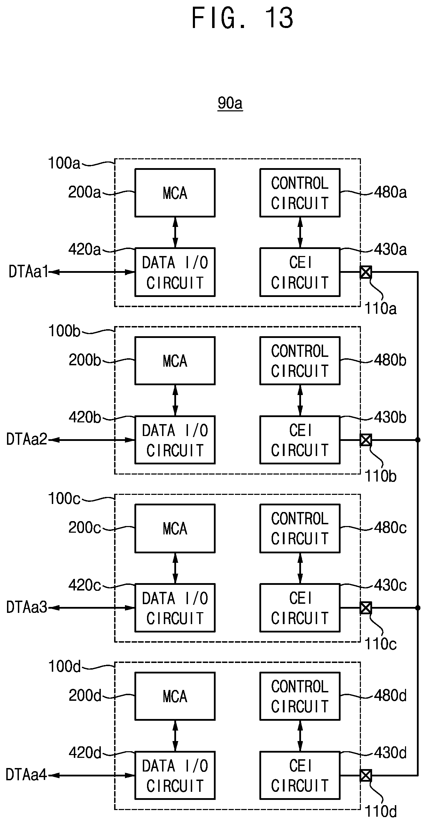

FIG. 13 illustrates four nonvolatile memory devices (nonvolatile memory chips) in the storage media in FIG. 1.

Referring to FIG. 13, a storage media 90a may include nonvolatile memory devices 100a, 100b, 100c and 100d and the nonvolatile memory devices 100a, 100b, 100c and 100d may be connected to the storage controller 50 through the media channel CHN1 as described with reference to FIG. 1.

The nonvolatile memory device 100a may include the memory cell array MCA 200a, the data I/O circuit 420a, the control circuit 480a, the CEI circuit 430a and the chip interface pin 110a and the data I/O circuit 420a may transmit and receive a corresponding data DTAa1 to and from the storage controller 50.

The nonvolatile memory device 100b may include a memory cell array 200b, a data I/O circuit 420b, a control circuit 480b, the CEI circuit 430b and a chip interface pin 110b and the data I/O circuit 420b may transmit and receive a corresponding data DTAa2 to and from the storage controller 50.

The nonvolatile memory device 100c may include a memory cell array 200c, a data I/O circuit 420c, a control circuit 480c, the CEI circuit 430c and a chip interface pin 110c and the data I/O circuit 420c may transmit and receive a corresponding data DTAa3 to and from the storage controller 50.

The nonvolatile memory device 100d may include a memory cell array 200d, a data I/O circuit 420d, a control circuit 480d, the CEI circuit 430d and a chip interface pin 110d and the data I/O circuit 420d may transmit and receive a corresponding data DTAa4 to and from the storage controller 50.

Each of the CEI circuits 430a, 430b, 430c and 430d may be connected to respective one of the chip interface pins 110a, 110b, 110c and 110d and the chip interface pins 110a, 110b, 110c and 110d are connected together.

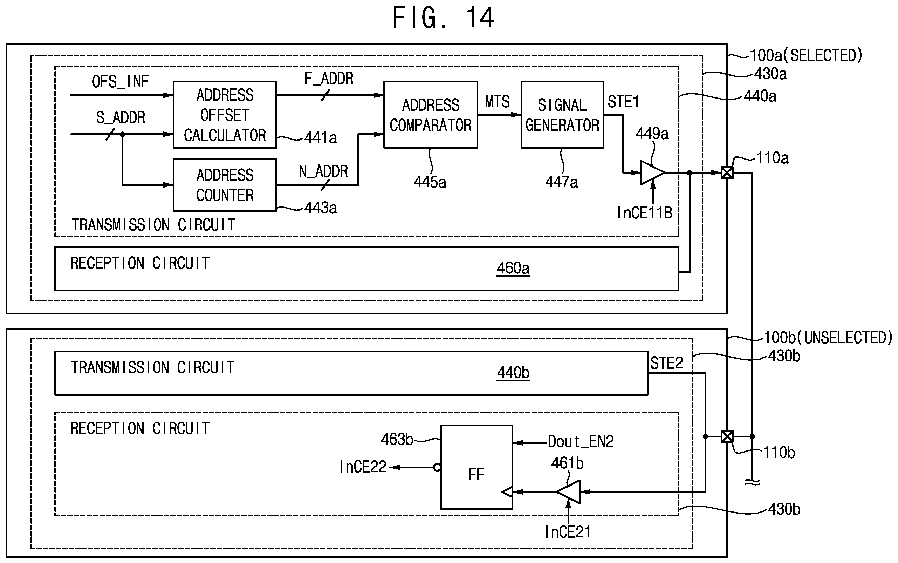

FIG. 14 illustrates CEI circuits in two nonvolatile memory devices in FIG. 13.

In FIG. 14, assuming that the nonvolatile memory device 100a is selected and the nonvolatile memory device 100b is unselected. In addition, the nonvolatile memory device 100a may be referred to a first nonvolatile memory chip and the nonvolatile memory device 100b may be referred to a second nonvolatile memory chip.

The nonvolatile memory device 100a may include the CEI circuit 430a and the chip interface pin 110a and the CEI circuit 430a may include the transmission circuit 440a and the reception circuit 460a that are connected to the chip interface pin 110a.

The nonvolatile memory device 100b may include the CEI circuit 430b and the chip interface pin 110b and the CEI circuit 430b may include a transmission circuit 440b and a reception circuit 460b that are connected to the chip interface pin 110b.

Referring to FIGS. 13 and 14, because the nonvolatile memory device 100a is selected, the CEI circuit 430a may operate in the transmission mode. The address offset calculator 441a may calculate the final address F_ADDR of a first read data (read from the memory cell array 200a in FIG. 4) based on the first start address S_ADDR and the offset information OFS_INF associated with a size of the first read data and may provide the final address F_ADDR to the address comparator 445a. The address counter 443a may generate the normal address N_ADDR that sequentially increments from the first start address S_ADDR by performing a counting operation based on the first start address S_ADDR and may provide the normal address N_ADDR to the address comparator 445a.

The address comparator 445a may generate the match signal MTS by comparing the final address F_ADDR and the normal address N_ADDR. The address comparator 445a may output the match signal MTS with a logic high level based on the normal address N_ADDR matching the final address F_ADDR.

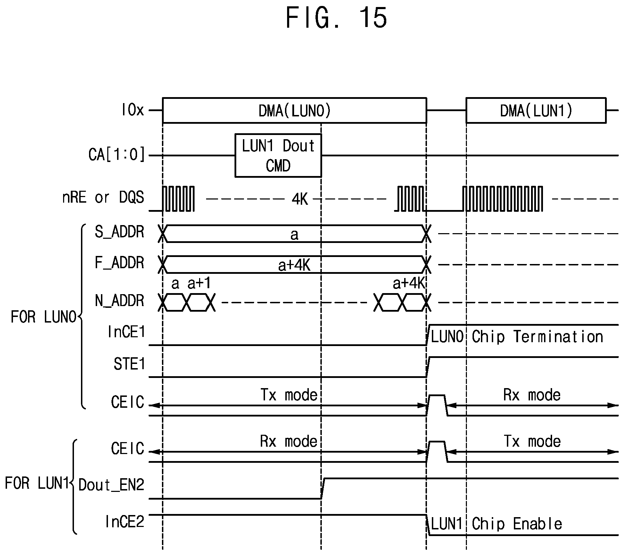

The signal generator 447a may generate a self termination signal STE1 based on the match signal MTS and provide the self termination signal STE to the buffer 449a. For example, the signal generator 447a may activate the self termination signal STE1 by switching from a first logic level to a second logic level (as illustrated in FIG. 15) based on the match signal MTS. The signal generator 447a may output the self termination signal STE transitioning to a logic high level based on the match signal MTS transitioning to a logic high level. The self termination signal STE1 may be referred to as a first self termination signal.

The buffer 449a may be enabled when the inverted internal chip enable signal InCE11b in a logic high level, and may transfer the self termination signal STE1 to the CEI circuit 430b through the chip interface pin 110a and the chip interface pin 110b.

Because the nonvolatile memory device 100b is unselected, the CEI circuit 430b may operate in the reception mode.

The buffer 461b may be enabled when the internal chip enable signal InCE21 in a logic high level and may provide the flip-flop 463b with the self termination signal STE1 provided from the nonvolatile memory device 100a.

The flip-flop 463b may generate the internal chip enable signal InCE22 by latching and inverting a data output enable signal Dout_EN2 based on an output of the buffer 461b and may provide the internal chip enable signal InCE22 to the control circuit 480b. The control circuit 480b may self-enable the nonvolatile memory device 100b based on transitioning of the internal chip enable signal InCE22.

The flip-flop 463b may generate the internal chip enable signal InCE22 with a logic low level by inverting the data output enable signal Dout_EN2 with a logic high level based on the output of the buffer 461b being in a logic high level.

The CEI circuit 430b in the nonvolatile memory device 100b that is self-enabled, may operate in the transmission mode. The nonvolatile memory device 100b may perform a second DMA operation to output a second read data from the memory cell array 200b to the storage controller 50 through the data I/O circuit 420b. The transmission circuit 440b may generate a self termination signal STE2 indicating that the second DMA operation is completed and may transfer the self termination signal STE2 to one of other nonvolatile memory devices through the chip interface pin 110b.

FIG. 15 is a timing diagram illustrating operation of the nonvolatile memory devices in FIG. 14 according to example implementations.

Referring to FIGS. 13 through 15, while the first nonvolatile memory device 100a performs a first DMA operation DMA(LUN0) to output a first read data from the memory cell array 200a to the storage controller 50 through I/O line IOx, the first nonvolatile memory device 100a receives a second data output command LUN1 Dout CMD from the storage controller 50 through command/address line CA[1:0].

The first read data may have a start address S_ADDR of 'a' and a final address F_ADDR of 'a+4K'. The address offset calculator 441a calculates the final address F_ADDR of 'a+4K' by summing an address offset '4K' to the start address S_ADDR of 'a' and the address counter 443a generates the normal address N_ADDR sequentially increments from the start address S_ADDR of 'a' by performing a counting operation based on the start address S_ADDR of 'a'. The address counter 443a may generate the normal address N_ADDR by performing a counting operation based on the read enable signal nRE or the data strobe signal DQS. The address comparator 445a outputs the match signal MTS with a logic high level based on the normal address N_ADDR matching the final address F_ADDR, and the signal generator 447a outputs the self termination signal STE1 transitioning to a logic high level based on the match signal MTS transitioning to a logic high level.

The control circuit 480a may transition an internal chip enable signal InCE1 to a logic high level based on transitioning of the self termination signal STE1. Therefore, the CEI circuit 430a may operate in the transmission mode before the internal chip enable signal InCE1 transitions to a logic high level and may operate in the reception mode after the internal chip enable signal InCE1 transitions to a logic high level.

The second nonvolatile memory device 100b transitions to the data output enable signal Dout_EN2 to a logic high level in response to receiving the second data output command LUN1 Dout CMD, the CEI circuit 430b in the second nonvolatile memory device 100b operates in the reception mode and the reception circuit 460b of the CEI circuit 430b receives the self termination signal STE1 through the chip interface pin 110b.

The buffer 461b provides the flip-flop 463b with the self termination signal STE1 provided from the nonvolatile memory device 100a. The flip-flop 463b generates the internal chip enable signal InCE22 by latching and inverting the data output enable signal Dout_EN2 based on an output of the buffer 461b and provides the internal chip enable signal InCE22 to the control circuit 480b. The control circuit 480b may self-enable the nonvolatile memory device 100b based on transitioning of the internal chip enable signal InCE22.

The first nonvolatile memory device 100b performs a second DMA operation DMA(LUN1) to output a second read data from the memory cell array 200b to the storage controller 50 through the I/O line IOx, the transmission circuit 440b may generate the self termination signal STE2 indicating that the second DMA operation is completed and may transfer the self termination signal STE2 to one of other nonvolatile memory devices through the chip interface pin 110b.

Therefore, in the storage device according to example implementations, the first nonvolatile memory device (e.g., the first nonvolatile memory chip) may perform a first DMA operation to output a first read data to the storage controller 50 based on a first data output command, may internally (e.g., selfishly) generate the self termination signal indicating that the first DMA operation is completed based on address and may transfer the self termination signal to the second nonvolatile memory device (e.g., the second nonvolatile memory chip). The second nonvolatile memory device may be self-enabled based on the self termination signal provided from the first nonvolatile memory device and may perform a second DMA operation (associated with a second data output command) to output a second read data to the storage controller 50 without a selection chip enable command from the storage controller 50. Therefore, the nonvolatile memory devices 110a, 110b, 100c and 110d may perform DMA operations successively without a selection chip enable command and a selection chip termination command from the storage controller 50, and thus may reduce I/O overhead.

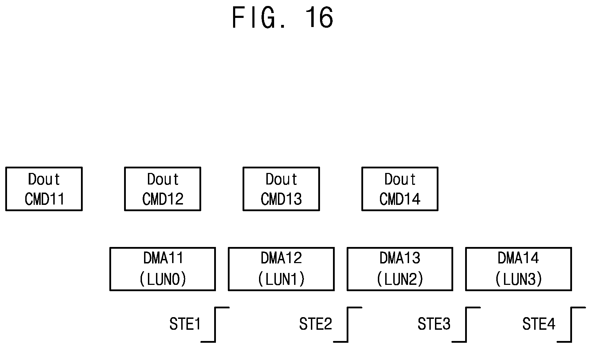

FIG. 16 illustrates that the nonvolatile memory devices in FIG. 13 perform DMA operations successively.

Referring to FIGS. 13 through 16, the first nonvolatile memory device 100a performs a first DMA operation DMA11(LUN0) to output a first read data to the storage controller 50 based on a first data output command Dout CMD11, and the CEI circuit 430a of the first nonvolatile memory device 100a may transition a first self termination signal STE1 to a logic high level.

While the first nonvolatile memory device 100a performs the first DMA operation DMA11(LUN0), the second nonvolatile memory device 100b may receive a second data output command Dout CMD12, may be self-enabled based on the first self termination signal STE1 received through the chip interface pin 110b and may perform a second DMA operation DMA12(LUN1) to output a second read data to the storage controller 50 based on the second data output command Dout CMD12. The CEI circuit 430b of the second nonvolatile memory device 100b may transition a second self termination signal STE2 to a logic high level.

While the second nonvolatile memory device 100b performs the second DMA operation DMA12(LUN1), the third nonvolatile memory device 100c may receive a third data output command Dout CMD13, may be self-enabled based on the second self termination signal STE2 received through the chip interface pin 110c and may perform a third DMA operation DMA13(LUN2) to output a third read data to the storage controller 50 based on the third data output command Dout CMD13. The CEI circuit 430c of the third nonvolatile memory device 100c may transition a third self termination signal STE3 to a logic high level.

While the third nonvolatile memory device 100c performs the third DMA operation DMA13(LUN2), the fourth nonvolatile memory device 100d may receive a fourth data output command Dout CMD14, may be self-enabled based on the third self termination signal STE3 received through the chip interface pin 110d and may perform a fourth DMA operation DMA14(LUN3) to output a fourth read data to the storage controller 50 based on the fourth data output command Dout CMD14. The CEI circuit 430d of the fourth nonvolatile memory device 100d may transition a fourth self termination signal STE4 to a logic high level.

In example implementations, the first read data, the second read data, the third read data and the fourth read data respectively output from the nonvolatile memory devices 100a, 100b, 100c and 100d may have different logical unit numbers (LUNs). The LUN may be a minimum unit capable of executing command independently.

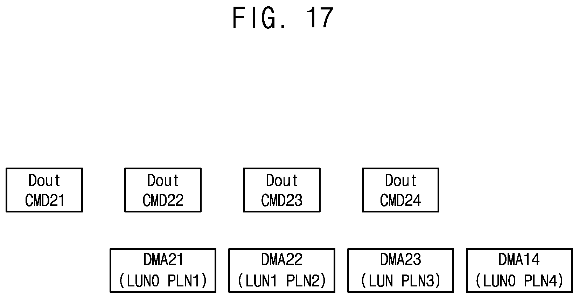

FIG. 17 illustrates an example operation of the nonvolatile memory device of FIG. 4 according to example implementations.

Referring to FIGS. 4 and 17, when data stored in the first through fourth memory planes 210, 220, 230 and 240 have the same LUN (that is, the data stored in the first through fourth memory planes 210, 220, 230 and 240 have LUN0), the CEI circuit 430a may repeat self termination and self enablement and a first read data, a second read data, a third read data and a fourth read data respectively read from the first through fourth memory planes 210, 220, 230 and 240 may be output to the storage controller 50 successively.

Referring to FIG. 5 together, the nonvolatile memory device 100a performs a first DMA operation DMA21 (LUN0 PLN1) to output a first read data from the first memory plane 210 to the storage controller 50 based on a first data output command Dout CMD21, the CEI circuit 430a may internally generate a self termination signal indicating that the first DMA operation DMA21 (LUN0 PLN1) is completed based on a start address associated with the first read data and may generate a self enable signal based on the self termination signal.

While the first DMA operation DMA21 (LUN0 PLN1) is being performed, the control circuit 480a may receive a second data output command Dout CMD22, the nonvolatile memory device 100a performs a second DMA operation DMA22 (LUN0 PLN2) to output a second read data from the second memory plane 220 to the storage controller 50 based on the self enable signal and the second data output command Dout CMD22, the CEI circuit 430a may internally generate a self termination signal indicating that the second DMA operation DMA22 (LUN0 PLN2) is completed based on a start address associated with the second read data and may generate a self enable signal based on the self termination signal.

While the second DMA operation DMA22 (LUN0 PLN2) is being performed, the control circuit 480a may receive a third data output command Dout CMD23, the nonvolatile memory device 100a performs a third DMA operation DMA23 (LUN0 PLN3) to output a third read data from the third memory plane 230 to the storage controller 50 based on the self enable signal and the third data output command Dout CMD23, the CEI circuit 430a may internally generate a self termination signal indicating that the third DMA operation DMA23 (LUN0 PLN3) is completed based on a start address associated with the third read data and may generate a self enable signal based on the self termination signal.

While the third DMA operation DMA23 (LUN0 PLN3) is being performed, the control circuit 480a may receive a fourth data output command Dout CMD24, and the nonvolatile memory device 100a performs a fourth DMA operation DMA24 (LUN0 PLN4) to output a fourth read data from the fourth memory plane 240 to the storage controller 50 based on the self enable signal and the fourth data output command Dout CMD24.

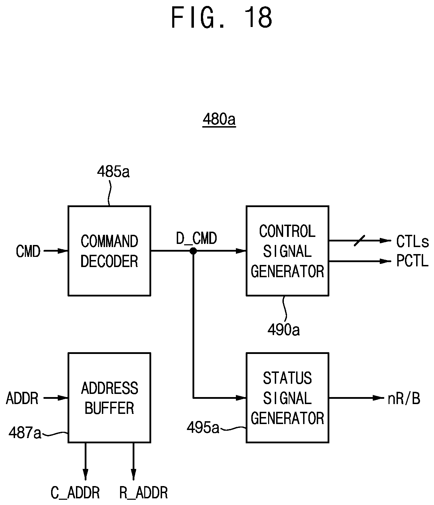

FIG. 18 is a block diagram illustrating an example of the control circuit in the nonvolatile memory device of FIG. 4 according to example implementations.

Referring to FIG. 18, the control circuit 480a may include a command decoder 485a, an address buffer 487a, a control signal generator 490a and a status signal generator 495a.

The command decoder 485a may decode the command CMD and provide a decoded command D_CMD to the control signal generator 490a and the status signal generator 495a.

The address buffer 487a may receive the address signal ADDR, provide the row address R_ADDR to the address decoder 300a and provide the column address C_ADDR to the data I/O circuit 420a.

The control signal generator 490a may receive the decoded command D_CMD, may generate the control signals CTLs and the page buffer control signal PCTL based on an operation directed by the decoded command D_CMD, may provide the control signals CTLs to the voltage generator 500a, and may provide the page buffer control signal PCTL to the page buffer circuits 410a, 410b, 410c and 410d.

The status signal generator 495a may receive the decoded command D_CMD, may monitor an operation directed by the decoded command D_CMD and may transition the status signal nR/B one of a ready state or a busy state based on whether the operation directed by the decoded command D_CMD is completed.

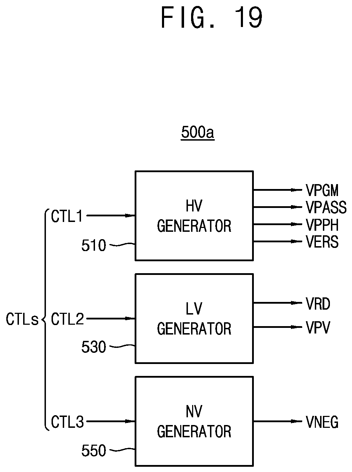

FIG. 19 is a block diagram illustrating an example of the voltage generator in the nonvolatile memory device of FIG. 4 according to example implementations.

Referring to FIG. 19, the voltage generator 500a may include a high voltage HV generator 510 and a low voltage LV generator 530. The voltage generator 500a may further include a negative voltage NV generator 550.

The high voltage generator 510 may be referred to as a first voltage generator, the low voltage generator 530 may be referred to as a second voltage generator and the negative voltage generator 550 may be referred to as a third voltage generator.

The high voltage generator 510 may generate a program voltage VPGM, a pass voltage VPASS, a high voltage VPPH, and an erase voltage VERS according to operations directed by the command CMD, in response to a first control signal CTL1.

The program voltage VPGM is applied to the selected word-line, the pass voltage VPASS may be applied to the unselected word-lines, the erase voltage VERS may be applied to a channel of cell strings included in a selected memory block. The high voltage VPPH may be applied to each gate of pass transistors coupled to word-lines, a string selection line and a ground selection line. The first control signal CTL1 may include a plurality of bits which indicate the operations directed by the decoded command D_CMD.

The low voltage generator 530 may generate a program verification voltage VPV and a read voltage VRD according to operations directed by the command CMD, in response to a second control signal CTL2. The second control signal CTL2 may include a plurality of bits which indicate the operations directed by the decode command D_CMD.

The negative voltage generator 550 may generate a negative voltage VNEG which has a negative level according to operations directed by the command CMD, in response to a third control signal CTL3. The third control signal CTL3 may include a plurality of bits which indicate the operations directed by the decoded command D_CMD. The negative voltage VNEG may be applied to a selected word-line and unselected word-lines during a program recovery period and may be applied to the unselected word-lines during a bit-line set-up period.

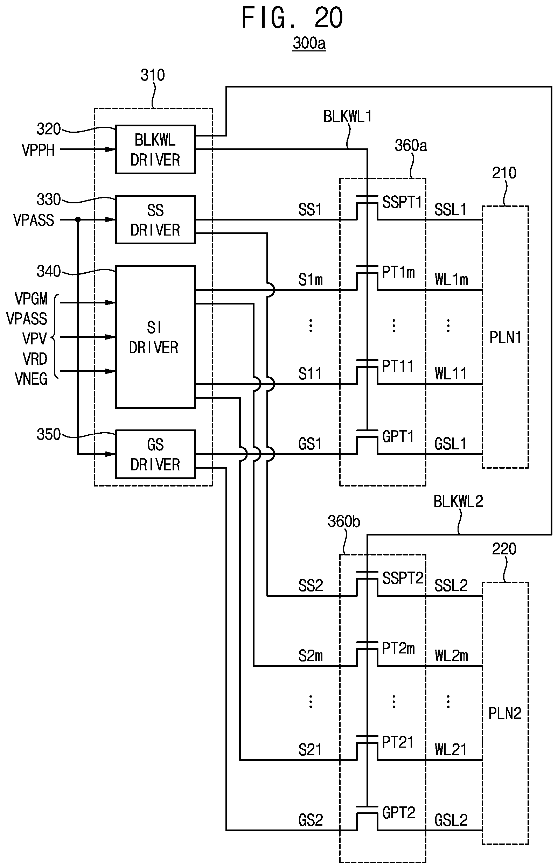

FIG. 20 is a block diagram illustrating an example of the address decoder in the nonvolatile memory device of FIG. 4 according to example implementations.

Referring to FIG. 20, the address decoder 300a may include a driver circuit 310 and pass switch circuits 360a and 360b.

The driver circuit 310 may transfer voltages provided from the voltage generator 500a to the memory cell array 200a in response to a block address. The driver circuit 310 may include a block selection driver BLKWL DRIVER 320, a string selection driver SS DRIVER 330, a driving line driver SI DRIVER 340 and a ground selection driver GS DRIVER 350.

The block selection driver 320 may supply a high voltage VPPH from the voltage generator 500 to the pass transistor circuits 360a and 360b in response to the block address. The block selection driver 320 may supply the high voltage VPPH to a block word-line BLKWL1 coupled to gates of a plurality of pass transistors GPT1, PT11~PT1m and SSPT1 in the pass transistor circuit 360a and may supply the high voltage VPPH to a block word-line BLKWL2 coupled to gates of a plurality of pass transistors GPT2, PT21~PT2m and SSPT2 in the pass transistor circuit 360b. The block selection driver 320 may control the application of various voltages such as a pass voltage, a program voltage, a read voltage to the memory cell array 200a.

The pass transistors GPT1, PT11~PT1m and SSPT1 may be coupled to the memory plane 210 through a ground selection line GSL1, a plurality of word-lines WL11~WL1m and a string selection line SSL1 and the pass transistors GPT2, PT21~PT2m and SSPT2 may be coupled to the memory plane 220 through a ground selection line GSL2, a plurality of word-lines WL21~WL2m and a string selection line SSL2.

The string selection driver 330 may supply voltage (for example, pass voltage VPASS) from the voltage generator 500a to the string selection lines SSL1 and SSL2 through the pass transistors SSPT1 and SSPT2 as string selection signals SS1 and SS2. During a program operation, the string selection driver 330 may supply the selection signals SS1 and SS2 so as to turn on all string selection transistors in a selected memory block.

The driving line driver 340 may supply the program voltage VPGM, the pass voltage VPASS, the verification voltage VPV, the read voltage VRD and the negative voltage VNEG from the voltage generator 500a to the word-lines WL11~WL1m through driving lines S11~S1m and the pass transistors PT11~PT1m and may supply the program voltage VPGM, the pass voltage VPASS, the verification voltage VPV, the read voltage VRD and the negative voltage VNEG to the word-lines WL21~WL2m through driving lines S21~S2m and the pass transistors PT21~PT2m.

The ground selection driver 350 may supply voltage (for example, pass voltage VPASS) from the voltage generator 500a to the ground selection lines GSL1 and GSL2 through the pass transistors GPT1 and GPT2 as ground selection signal GS1 and GS2.

The pass transistors GPT1, PT11~PT1m and SSPT1 are configured such that the ground selection line GSL1, the word-lines WL11~WL1m and the string selection line SSL1 are electrically connected to corresponding driving lines, in response to activation of the high voltage VPPH on the block word-line BLKWL2. In example implementations, each of the pass transistors GPT1, PT11~PT1m, SSPT1 may include a high voltage transistor capable of enduring high-voltage. The pass transistors GPT2, PT21~PT2m and SSPT2 are configured such that the ground selection line GSL2, the word-lines WL21~WL2m and the string selection line SSL2 are electrically connected to corresponding driving lines, in response to activation of the high voltage VPPH on the block word-line BLKWL2. In example implementations, each of the pass transistors GPT2, PT21~PT2m, SSPT2 may include a high voltage transistor capable of enduring high-voltage.

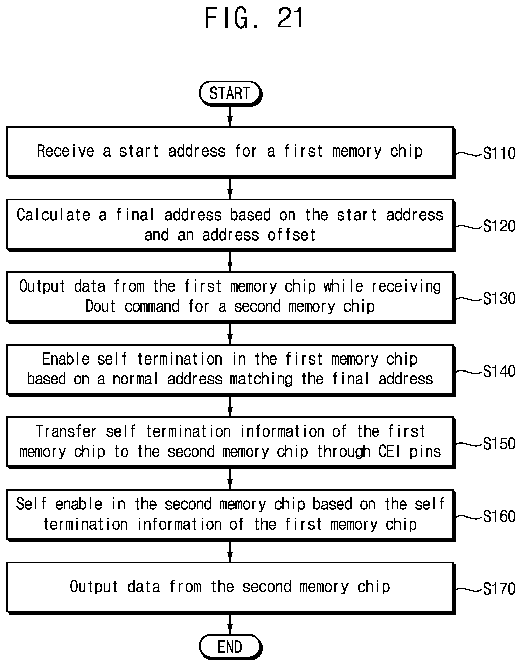

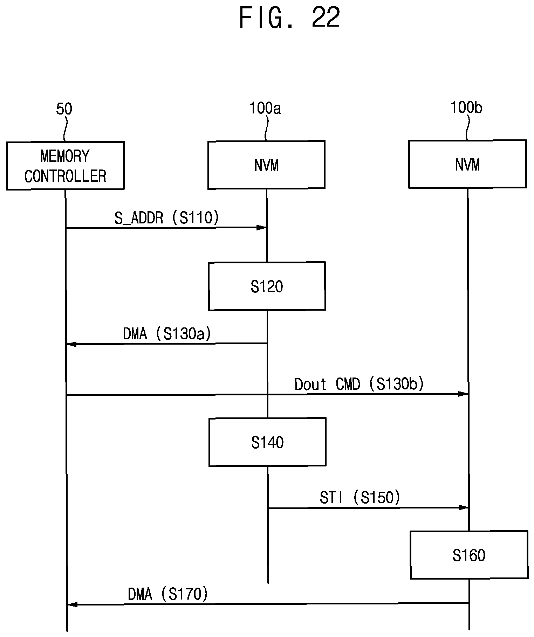

FIG. 21 is a flowchart illustrating an example operation of the nonvolatile memory device and FIG. 22 is a ladder diagram illustrating an example operation of the nonvolatile memory device, according to example implementations.

Referring to FIGS. 1 and 4 through to 22, the first nonvolatile memory device 100a may receive a start address S_ADDR associated with a first read data from the storage controller 50 (operation S110).

The CEI circuit 430a of the first nonvolatile memory device 100a may calculate a final address F_ADDR of the first read data based on the start address S_ADDR and an address offset indicating a size of the first read data (operation S120).

While the first nonvolatile memory device 100a performs a first read operation to output the first read data to the storage controller 50 based on a first data output command (operation S130a), the second nonvolatile memory device 100b receives a second data output command from the storage controller 50 (operation S130b).

The CEI circuit 430a of the first nonvolatile memory device 100a generates a normal address N_ADDR that sequentially increments by performing a counting operation based on the start address S_ADDR and enables a self termination based on the normal address N_ADDR matching the final address F_ADDR (operation S140).

The CEI circuit 430a of the first nonvolatile memory device 100a may transfer a self termination information to the CEI circuit 430b of the second nonvolatile memory device 100b through the chip interface pins 110a and 110b (operation S150).

The second nonvolatile memory device 100b may be self-enabled based on the self termination information provided from the first nonvolatile memory device 100a (operation S160) and the second nonvolatile memory device 100b performs a second DMA operation to output a second read data to the storage controller 50 based on the second data output command (operation S170).

The operations S130a and S130b in FIG. 22 may correspond to the operation S130 in FIG. 21.

Therefore, in the storage device according to example implementations, the first nonvolatile memory device (e.g., the first nonvolatile memory chip) may perform a first DMA operation to output a first read data to the storage controller 50 based on a first data output command, may internally (e.g., selfishly) generate the self termination signal indicating that the first DMA operation is completed based on address and may transfer the self termination signal to the second nonvolatile memory device (e.g., the second nonvolatile memory chip). The second nonvolatile memory device may be self-enabled based on the self termination signal provided from the first nonvolatile memory device and may perform a second DMA operation (associated with a second data output command) to output a second read data to the storage controller 50 without a selection chip enable command from the storage controller 50. Therefore, the nonvolatile memory devices 110a, 110b, 100c and 110d may perform DMA operations successively without a selection chip enable command and a selection chip termination command from the storage controller 50, and thus may reduce I/O overhead.

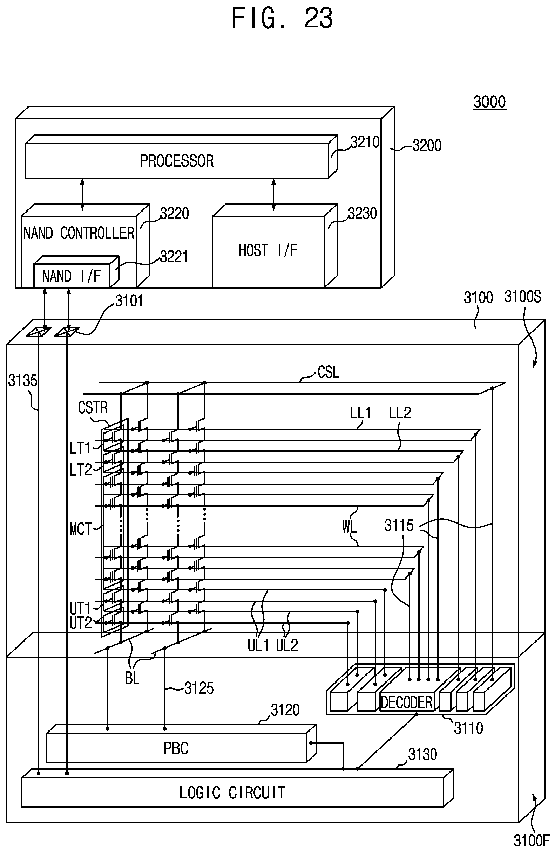

FIG. 23 is a block diagram illustrating an electronic system including a semiconductor device according to some example implementations.

Referring to FIG. 23, an electronic system 3000 may include a semiconductor device 3100 and a controller 3200 electrically connected to the semiconductor device 3100. The electronic system 3000 may be a storage device including one or a plurality of semiconductor devices 3100 or an electronic device including a storage device. For example, the electronic system 3000 may be a solid state drive (SSD) device, a universal serial bus (USB), a computing system, a medical device, or a communication device that may include one or a plurality of semiconductor devices 3100.

The semiconductor device 3100 may be or may include a non-volatile memory device, for example, a nonvolatile memory device that is illustrated with reference to FIGS. 4 to 20. The semiconductor device 3100 may include a first structure 3100F and a second structure 3100S on the first structure 3100F. The first structure 3100F may be a peripheral circuit structure including a decoder circuit 3110, a page buffer circuit (PBC) 3120, and a logic circuit 3130. The second structure 3100S may be a memory cell structure including a bit-line BL, a common source line CSL, word-lines WL, first and second upper gate lines UL1 and UL2, first and second lower gate lines LL1 and LL2, and memory cell strings CSTR between the bit line BL and the common source line CSL.

In the second structure 3100S, each of the memory cell strings CSTR may include lower transistors LT1 and LT2 adjacent to the common source line CSL, upper transistors UT1 and UT2 adjacent to the bit-line BL, and a plurality of memory cell transistors MCT between the lower transistors LT1 and LT2 and the upper transistors UT1 and UT2. The number of the lower transistors LT1 and LT2 and the number of the upper transistors UT1 and UT2 may be varied in accordance with example implementations.

In some example implementations, the upper transistors UT1 and UT2 may include string selection transistors, and the lower transistors LT1 and LT2 may include ground selection transistors. The lower gate lines LL1 and LL2 may be gate electrodes of the lower transistors LT1 and LT2, respectively. The word lines WL may be gate electrodes of the memory cell transistors MCT, respectively, and the upper gate lines UL1 and UL2 may be gate electrodes of the upper transistors UT1 and UT2, respectively.

In some example implementations, the lower transistors LT1 and LT2 may include a lower erase control transistor LT1 and a ground selection transistor LT2 that may be connected with each other in serial. The upper transistors UT1 and UT2 may include a string selection transistor UT1 and an upper erase control transistor UT2. At least one of the lower erase control transistor LT1 and the upper erase control transistor UT2 may be used in an erase operation for erasing data stored in the memory cell transistors MCT through a gate induced drain leakage (GIDL) phenomenon.

The common source line CSL, the first and second lower gate lines LL1 and LL2, the word lines WL, and the first and second upper gate lines UL1 and UL2 may be electrically connected to the decoder circuit 3110 through first connection wirings 3115 extending to the second structure 3100S from the first structure 3100F. The bit-lines BL may be electrically connected to the page buffer circuit 3120 through second connection wirings 3125 extending to the second structure 3100S from the first structure 3100F.

In the first structure 3100F, the decoder circuit 3110 and the page buffer circuit 3120 may perform a control operation for at least one selected memory cell transistor among the plurality of memory cell transistors MCT. The decoder circuit 3110 and the page buffer circuit 3120 may be controlled by the logic circuit 3130. The semiconductor device 3100 may communicate with the controller 3200 through an input/output pad 3101 electrically connected to the logic circuit 3130. The input/output pad 3101 may be electrically connected to the logic circuit 3130 through an input/output connection wiring 3135 extending to the second structure 3100S from the first structure 3100F.

The controller 3200 may include a processor 3210, a NAND controller 3220, and a host interface (I/F) 3230. The electronic system 3000 may include a plurality of semiconductor devices 3100, and in this case, the controller 3200 may control the plurality of semiconductor devices 3100.

The processor 3210 may control operations of the electronic system 3000 including the controller 3200. The processor 3210 may be operated by firmware, and may control the NAND controller 3220 to access the semiconductor device 3100. The NAND controller 3220 may include a NAND interface 3221 for communicating with the semiconductor device 3100. Through the NAND interface 3221, control command for controlling the semiconductor device 3100, data to be written in the memory cell transistors MCT of the semiconductor device 3100, data to be read from the memory cell transistors MCT of the semiconductor device 3100, etc., may be transferred. The host interface 3230 may provide communication between the electronic system 3000 and an outside host. When control command is received from the outside host through the host interface 3230, the processor 3210 may control the semiconductor device 3100 in response to the control command.

A nonvolatile memory device or a storage device according to example implementations may be packaged using various package types or package configurations.

The foregoing is illustrative of example implementations and is not to be construed as limiting thereof. Although a few example implementations have been described, those skilled in the art will readily appreciate that many modifications are possible in the example implementations without materially departing from the novel teachings and advantages of the present disclosure. Accordingly, all such modifications are intended to be included within the scope of the present disclosure as defined in the claims.

## Claims

1. A storage device (10) comprising:
a plurality of nonvolatile memory chips (100a, 100b, 100c, 100d) including a first nonvolatile memory chip (100a) and a second nonvolatile memory chip (100b); and
a storage controller (50) configured to control the plurality of nonvolatile memory chips (100a, 100b, 100c, 100d),
wherein the first nonvolatile memory chip (100a) includes
a first memory cell array (200a),
a first chip enable interface circuit (430a),
a first chip interface pin (110a) connected to the first chip enable interface circuit (430), and
a first control circuit (480a) configured to control an operation of the first nonvolatile memory chip (100a),
wherein the first nonvolatile memory chip (100a) is configured to, based on a first data output command (Dout CNM 11) from the storage controller (50), perform a first direct memory access (DMA) operation (DMA11(LUN0)) to transmit a first read data from the first memory cell array (200a) to the storage controller (50),
wherein the first chip enable interface circuit (430a) is configured to generate a first self termination signal (STE1) indicating that the first DMA operation (DMA11(LUN0)) is completed based on a first start address (S_ADDR) associated with the first read data, and provide the first self termination signal (STE1) to the second nonvolatile memory chip (100b) through the first chip interface pin (110a),
wherein the second nonvolatile memory chip (100b) includes (i) a second chip interface pin (110b) configured to receive the first self termination signal (STE1) and (ii) a second chip enable interface circuit (430b) connected to the second chip interface pin (110b), and
wherein the second nonvolatile memory chip (100b) is configured to be self-enabled based on the first self termination signal (STE1) from the first nonvolatile memory chip (100a).

2. The storage device (10) of claim 1, wherein the first control circuit (480a) is configured to:
receive a first chip enable signal from the storage controller (50);
activate an internal chip enable signal (InCE11) based on the first chip enable signal; and
provide the internal chip enable signal (InCE11) to the first chip enable interface circuit (430a),
wherein the first chip enable interface circuit (430a) is configured to operate in a transmission mode based on the internal chip enable signal (InCE11) being activated and activate the first self termination signal (STE1).

3. The storage device (10) of claim 2,
wherein the first control circuit (480a) is configured to deactivate the internal chip enable signal (InCE11) based on activation of the first self termination signal (STE1), and
wherein the first chip enable interface circuit (430a) is configured to operate in a reception mode based on the internal chip enable signal (InCE11) being deactivated.

4. The storage device (10) of any preceding claim, wherein the first chip enable interface circuit (430a) includes a transmission circuit (440a) and a reception circuit (460a) that are connected to the first chip interface pin (110a),
wherein the transmission circuit (440a) is configured to operate based on an internal chip enable signal (InCE11) being in a logic low level,
wherein the reception circuit (460a) is configured to operate based on the internal chip enable signal (InCE11) being in a logic high level
wherein the transmission circuit (440a) includes:
an address offset calculator (441a) configured to calculate a final address (F_ADDR) of the first read data based on the first start address (S_ADDR) and an offset information (OFS_INF) associated with a size of the first read data;
an address counter (443a) configured to generate a normal address (N_ADDR) that sequentially increments from the first start address (S_ADDR) by performing a counting operation based on the first start address (S_ADDR);
an address comparator (445a) configured to generate a match signal (MTS) by comparing the final address (F-ADDR) and the normal address (N_ADDR);
a signal generator (447a) configured to generate the first self termination signal (STE1) based on the match signal (MTS); and
a buffer (449a) configured to selectively provide the first self termination signal (STE1) to the first chip interface pin (110a) based on an inverted internal chip enable signal (InCE11B) that is obtained by inverting the internal chip enable signal (InCE11), the internal chip enable signal (InCE11) being based on the first chip enable signal.

5. The storage device (10) of claim 4, wherein:
the address comparator (445a) is configured to activate the match signal (MTS) based on the normal address (N_ADDR) matching the final address (F_ADDR);
the signal generator (447a) is configured to activate the first self termination signal (STE1) based on the match signal (MTS) being activated; and
the buffer (449a) is configured to, based on the inverted internal chip enable signal (InCE11B) having a logic high level, provide the first self termination signal (STE1) to the first chip interface pin (110a), and wherein the first control circuit (480a) is configured to:
activate the internal chip enable signal (InCE11) based on the first chip enable signal and provide the internal chip enable signal (InCE11) to the first chip enable interface circuit (430a); and
deactivate the internal chip enable signal (InCE11) based on the first self termination signal (STE1) being activated.

6. The storage device (10) of any preceding claim, wherein the second nonvolatile memory chip (100b) includes a second memory cell array (200b) and a second control circuit (480b) configured to control an operation of the second nonvolatile memory chip (100b),
wherein the second nonvolatile memory chip (100b) is configured to receive a second data output command (Dout CMD12) from the storage controller (50) and activate a data output enable signal (Dout_EN2) based on the second data output command (Dout CMD12) based on the first nonvolatile memory chip (100a) performing the first DMA operation (DMA11(LUN0)), and
wherein the second nonvolatile memory chip (100b) is configured to (i) be self-enabled based on the first self termination signal (STE1) from the first nonvolatile memory chip (100a) and on the data output enable signal (Dout_EN2) and (ii) perform a second DMA operation (DMA12(LUN1)) to transmit a second read data from the second memory cell array (200b) to the storage controller (50).

7. The storage device (10) of claim 6, wherein the second chip enable interface circuit (430b) is configured to:
activate a second internal chip enable signal (InCE22) based on the first self termination signal (STE1) being activated; and
provide the second internal chip enable signal (InCE22) to the second control circuit (480b), and
wherein the second control circuit (480b) is configured to self-enable the second nonvolatile memory chip (100b) based on the second internal chip enable signal (InCE22) being activated.

8. The storage device (10) of claim 7, wherein the second chip enable interface circuit (430b) includes a transmission circuit (440b) and a reception circuit (460b) that are connected to the second chip interface pin (110b),
wherein the reception circuit (460b) is configured to operate based on a first internal chip enable signal (InCE21) being in a logic high level, and
wherein the transmission circuit (440b) is configured to operate based on the first internal chip enable signal (InCE21) being in a logic low level.

9. The storage device (10) of claim 8, wherein the reception circuit (460b) includes:
a buffer (461b) connected to the second chip interface pin (110b), the buffer (461b) configured to receive the first self terminal signal (STE1); and
a flip-flop (463b) configured to output the second internal chip enable signal (InCE22) by latching the data output enable signal (Dout_EN2) based on an output of the buffer (461b).

10. The storage device (10) of claim 9, wherein the buffer (461b) is configured to provide the first self termination signal (STE1) to the flip-flop (463b) based on the first internal chip enable signal (InCE21) being activated.

11. The storage device (10) of claim 9 or claim 10, wherein the flip-flop (463b) is configured to output the second internal chip enable signal (InCE22) by inverting the data output enable signal (Dout_EN2) based on a rising transition of the output of the buffer (461b).

12. The storage device (10) of any of claims 6-11,
wherein the second nonvolatile memory chip (100b) is configured to perform the second DMA operation (DMA12(LUN1)) after the second nonvolatile memory chip (100b) is self-enabled,
wherein the second chip enable interface circuit (430b) is configured to:
generate a second self-termination signal (STE2) indicating that the second DMA operation (DMA12(LUN1)) is completed based on a second start address associated with the second read data; and
provide, through the second chip interface pin (110b), the second self-termination signal (110b) to a nonvolatile memory chip (100c) of a first group of nonvolatile memory chips (100c, 100d) of the plurality of nonvolatile memory chips (100a, 100b, 100c, 100d), wherein the first group of nonvolatile memory chips (100c, 100d) excludes the second nonvolatile memory chip (100b).

13. The storage device (10) of claim 12, wherein the nonvolatile memory chip (100c) of the first group of nonvolatile memory chips (100c, 100d) is configured to be self-enabled based on the second self-termination signal (STE2), and
wherein the first read data and the second read data have different logical unit numbers.

14. A nonvolatile memory device (100a) comprising:
a memory cell array (200a) including a plurality of memory planes (210, 220, 230, 240) that include a first memory plane (210) and a second memory plane (220);
a plurality of page buffer circuits (410a, 410b, 410c, 410d) corresponding to the plurality of memory planes (210, 220, 230, 240), each of the plurality of page buffer circuits (410a, 410b, 410c, 410d) connected to a respective one of the plurality of memory planes (210, 220, 230, 240) through corresponding bit-lines (BLs);
a data input/output (I/O) circuit (420a) connected to the plurality of page buffer circuits (410a, 410b, 410c, 410d) through corresponding data lines (DLs);
a chip enable interface circuit (430a);
a chip interface pin (110a) connected to the chip enable interface circuit (430a); and
a control circuit (480a) configured to control an operation of the nonvolatile memory device (100a),
wherein the control circuit (480a) is configured to, based on a first data output command (Dout CMD21) from a storage controller (50),
perform a first direct memory access (DMA) operation (DMA21 LUN0 PLN1) to output a first read data from the first memory plane (210) to a storage controller (50) through the data I/O circuit (420a), and
receive a second data output command (Dout CMD22) from the storage controller (50) based on the first DMA operation (DMA21 LUN0 PLN1) is being performed,
wherein the chip enable interface circuit (430a) is configured to generate a self termination signal (STE) indicating that the first DMA operation (DMA21 LUN0 PLN1) is completed based on a first start address (S_ADDR) associated with the first read data and generate a self enable signal based on the self termination signal (STE), and
wherein the control circuit (480a) is configured to, in response to the second data output command and the self enable signal, perform a second DMA operation DMA22 (LUN1 PLN2) to output a second read data from the second memory plane (220) to the storage controller through the data I/O circuit (420a).

15. The nonvolatile memory device (100a) of claim 14, wherein the chip enable interface circuit (430a) includes a transmission circuit (440a) and a reception circuit (460a) that are connected to the chip interface pin (110a),
wherein the transmission circuit (440a) is configured to generate the self termination signal (STE1) indicating that the first DMA operation (DMA21 LUN0 PLN1) is completed based on the first start address (S_ADDR) and transfer the self termination signal (STE) to the reception circuit (460a) through the chip interface pin (110a), and
wherein the reception circuit (460a) is configured to generate the self enable signal based on the self termination signal (STE) and provide the self enable signal to the control circuit (480a).
